(19) Europäisches Patentamt
European Patent Office
Office européen des brevets

(11) **EP 1 872 941 A1**

(12) **EUROPEAN PATENT APPLICATION**
published in accordance with Art. 153(4) EPC

(43) Date of publication:
**02.01.2008 Bulletin 2008/01**

(51) Int Cl.:
**B32B 27/34** *(2006.01)*

(21) Application number: **05757943.5**

(22) Date of filing: **01.07.2005**

(86) International application number:
**PCT/JP2005/012623**

(87) International publication number:
**WO 2006/114901 (02.11.2006 Gazette 2006/44)**

(84) Designated Contracting States:
**AT BE BG CH CY CZ DE DK EE ES FI FR GB GR HU IE IS IT LI LT LU MC NL PL PT RO SE SI SK TR**

(30) Priority: **18.04.2005 JP 2005119994**
**18.04.2005 JP 2005119995**
**19.04.2005 JP 2005121179**
**19.04.2005 JP 2005121180**

(71) Applicant: **Toyo Boseki Kabushiki Kaisha**
**Osaka-shi, Osaka 530-8230 (JP)**

(72) Inventors:
• **MAEDA, Satoshi c/o Toyo Boseki Kabushiki Kaisha**
**Shiga 5200292 (JP)**

• **KAWAHARA, Keizo c/o Toyo Boseki Kabushiki Kaisha**
**Shiga 5200292 (JP)**
• **TSUTSUMI, M. c/o Toyo Boseki Kabushiki Kaisha**
**Shiga 5200292 (JP)**
• **YOSHIDA, Takefumi c/o Toyo Boseki Kabushiki Kaisha**
**Shiga 5200292 (JP)**

(74) Representative: **Müller-Boré & Partner**
**Patentanwälte**
**Grafinger Strasse 2**
**81671 München (DE)**

(54) **THIN FILM-LAMINATED POLYIMIDE FILM AND FLEXIBLE PRINTED WIRING BOARD**

(57) The thin film-laminated polyimide film contains a substrate film and a thin film layer formed at least on one surface of the substrate film. The substrate film is made of a polyimide film showing a degree of curl after a heat treatment at 300˚C of not more than 10%. Use of this thin film-laminated polyimide film as a substrate of electronic parts such as solar battery, capacitor and the like exposed to high temperatures prevents easy development of warpage and distortion during production, and can improve quality and yield of electronic parts.

EP 1 872 941 A1

## Description

## Technical Field

The present invention relates to a thin film-laminated polyimide film used for a flexible printed circuit substrate and the like that play an important role in the down-sizing and lightening of electronic devices and electronic parts. More particularly, the present invention relates to a thin film-laminated polyimide film to be used for a flexible printed circuit substrate subjected to TAB, COF, PGA etc. for semiconductor packaging and the like, which comprises a polyimide film having particular properties as a substrate film, wherein the thin film-laminated polyimide film made conductive shows less warpage and curling.

## Background Art

Conventionally, metallized polyimide films to be used for what is called bonding type flexible printed circuit substrates, in which a polyimide film is bonded with a metal foil such as copper foil, aluminum foil and the like with an adhesive, are known. Such films have the following problems considered to be attributable to the adhesive to be used.

Firstly, lower size precision due to the inferior thermal properties of the film and degraded electric properties due to impurity ion contamination, which in turn imposes a limitation on high density wiring. In addition, processability such as thickness of adhesive layer, formation of through-hole for both sides and the like are defectively degraded. Therefore, the films are extremely disadvantageous in many aspects in achieving the down sizing and lightening.

On the other hand, what is called a thin film type conducted (metallized) polyimide film for a flexible printed circuit substrate free of an adhesive layer, wherein a metal layer is formed by a method comprising dry plating method such as vacuum vapor deposition, sputtering, ion plating, CVD and the like without using an adhesive on a polyimide film, has been proposed.

In recent years, moreover, all equipment represented by electronic devices and the like are moving toward down-sizing and lightening using such flexible functional materials, which are thin film laminates, and a method utilizing a thinner film containing the above-mentioned dry plating has been frequently employed. In dry plating, adhesion of a thin film to a substrate film, improved thin film performance and the like are more easily achieved at higher temperatures. Thus, a more heat-resistant polyimide film is frequently used by dry plating as a highly functional thin-film formation laminate film.

For example, a carrier for a flexible electric circuit wherein a chrome ceramic vapor deposition layer, a copper or copper alloy vapor deposition layer and a copper plating layer are sequentially formed on an insulating film has been proposed (JP-A-04-329690). In addition, there is a flexible film capacitor wherein a 5 - 500 $\mu$m polyimide film is used as a substrate film, on the surface of the film is formed a copper foil by a copper sputtering method and the like to give an electrode, the copper foil electrode is used as an external terminal, which copper foil electrode is partly exposed, and an electrode protection cover is formed from polyimide and the like (JP-A-09-017691). Moreover, a production method of a metal-film laminate plate comprising randomly disposing metal oxides formed by plasma on a polymer film, and then forming a metal vapor deposition layer and a metal plating layer has been proposed (JP-A-04-290742). Furthermore, a production method of a circuit material comprising forming, on an electrically insulating support film, a chrome/chrome oxide sputtering layer having a thickness of 25 - 150 angstrom and a copper sputtering layer having a thickness of less than 1 micron, and applying a photoresist composition to the copper layer has been proposed (JP-A-62-293689).

As is clear from these examples, conventional thin film type metallized polyimide films are prepared by first forming some underlayer on a polyimide film, and then forming copper thereon, which is a good conductive material. No chemical binding force exists between the metal layer, which is a conducted layer, and the polyimide film, which is a substrate, and the micro underlayer is anchored to the substrate surface at the micro level, and the adhesion to copper is achieved by metal/metal junction via an underlayer.

When a nonmetal or metal oxide is used as an underlayer, removal thereof by etching is difficult. In addition, due to the reduction action in an electroless plating step and the like, the metal oxide remaining between lines is reduced to be a conductive metallic foreign substance that may cause insulation failure between lines.

In addition, chrome oxide often used as an underlayer is considered a compound unpreferable for the environmental hygiene. When a metal other than copper is used as an underlayer, whether or not the underlayer can be removed with a copper etching solution becomes the problem. When a metal with higher corrosion resistance than copper is used, removal of the undermetal becomes insufficient, which may degrade the insulation property between lines. In the case of a metal more easily etchable than copper, the underlayer is easily overetched and the effective adhesion strength of the conductor tends to decrease. Even if the decrease in the insulation property due to the undermetal itself is of a level free of problem, the remaining metal may exhibit a catalyst activity during electroless plating in a later step, and the plated metal may be precipitated between lines, possibly causing a short-circuit. Furthermore, the undermaterial remaining between wirings is feared to lower the migration resistance between wirings.

From these viewpoints, in recent years, metallized polyimide films using a nickel-chrome alloy as an underlayer have been attracting attention, and an example of a metallized polyimide film wherein a nickel-chrome alloy layer is used as an underlayer for a conventional polyimide film, and copper is applied thick thereon is shown (JP-A-2002-252257).

As the polyimide film, a polyimide elongated film made of a polyimide containing 3,3',4,4'-benzophenonetetracarboxylic acid as an acid component, and p-phenylenediamine and p-diaminodiphenyl ether (4,4'-oxydianiline) as a diamine component in the main chain as constitution units has been proposed (JP-A-09-328544). A polyimide elongated film obtained by polymerization·dehydration using biphenyltetracarboxylic acid dianhydride and/or pyromellitic acid dianhydride as the aromatic tetracarboxylic acid component and p-phenylenediamine and/or diaminodiphenyl ether as an aromatic diamine component has also been proposed (JP-A-09-188763).

In addition, as a polyimide elongated film having a high elastic modulus, a polyimide benzoxazole film made of a polyimide having a benzoxazole ring in the main chain has been proposed (JP-A-06-056992).

Furthermore, a polyimide elongated film having less curling at 25°C by setting the orientation ratio of the front and the back of the polyimide elongated film to a value not higher than a given value has also been proposed (JP-A-2000-085007).

**Disclosure of the Invention**

Conventionally known substrate films made of a polyimide film or a polyimide benzoxazole film are inferior in the shape retainability and stiffness as compared to substrates made of ceramic. In addition, they have problem of easy occurrence of warpage and distortion during production of electronic parts due to the property difference within the film. Particularly, film warpage and distortion easily occurred during lamination of a thin film on a substrate film by dry plating. In addition, in an attempt to eliminate the warpage and distortion of a film, a measure to reduce apparent film warpage was employed by a heat treatment while stretching the film and the like. However, even if apparent film warpage, namely, exteriorized film warpage etc., could be eliminated, the problem of potential distortion that could be exteriorized by a treatment at a high temperature to cause curling, which treatment is particularly necessary for high temperature processing for the application of electronic parts, has not been solved. Accordingly, even if a film shows small apparent warpage, if it permits curling during processing, the yield of production decreases and high quality electronic parts are often difficult to obtain.

The present invention aims at provision of a thin film-laminated polyimide film superior in the planarity and homogeneity, which is preferable for a substrate for electronic parts, which polyimide film uses, as a substrate film, a polyimide film superior in heat resistance with less warpage and curling even after a treatment at a high temperature.

The present inventors have conducted intensive studies and found that a polyimide film having a degree of curl at 300°C is not more than 10% is used as a substrate film for an FPC (flexible printed circuit board), a TAB tape, a COF tape film, a solar battery, a capacitor, a display, an anti-reflective material and the like, a high quality and uniform FPC (flexible printed circuit board), TAB tape, COF tape film, solar battery, capacitor, display or anti-reflective material can be obtained, which resulted in the completion of the present invention.

Accordingly, the present invention has the following constitution.

1. A thin film-laminated polyimide film comprising a polyimide film having a degree of curl after a heat treatment at 300°C of not more than 10% as a substrate film, wherein a thin film layer is formed on at least one surface of the substrate film.

2. The thin film-laminated polyimide film of the above-mentioned 1, wherein the degree of curl after a heat treatment at 300°C is not more than 8%.

3. The thin film-laminated polyimide film of the above-mentioned 1 or 2, wherein the polyimide film is made of a polyimide obtained by reacting aromatic tetracarboxylic acid with aromatic diamine.

4. The thin film-laminated polyimide film of the above-mentioned 3, wherein the polyimide comprises at least a pyromellitic acid residue as an aromatic tetracarboxylic acid residue, and at least a diaminodiphenyl ether residue as an aromatic diamine residue.

5. The thin film-laminated polyimide film of the above-mentioned 4, which further comprises a biphenyltetracarboxylic acid residue as an aromatic tetracarboxylic acid residue, and further comprises a p-phenylenediamine residue as an aromatic diamine residue.

6. The thin film-laminated polyimide film of the above-mentioned 3, wherein the polyimide comprises at least a biphenyltetracarboxylic acid residue as an aromatic tetracarboxylic acid residue, and comprises at least a phenylenediamine residue as an aromatic diamine residue.

7. The thin film-laminated polyimide film of any one of the above-mentioned 1 - 6, wherein the thin film layer is a metal thin film layer.

8. The thin film-laminated polyimide film of the above-mentioned 7, wherein the metal thin film layer is formed by dry plating method.

9. The thin film-laminated polyimide film of the above-mentioned 7 or 8, wherein the metal thin film layer is formed via an underlayer.

10. The thin film-laminated polyimide film of any one of the above-mentioned 7 - 9, wherein a metal thick film layer is laminated on the metal thin film layer.

11. The thin film-laminated polyimide film of the above-mentioned 10, wherein the metal thick film layer is formed by wet plating method.

12. The thin film-laminated polyimide film of any one of the above-mentioned 1 - 6, wherein the thin film layer is made of a nonmetal layer.

13. The thin film-laminated polyimide film of the above-mentioned 12, wherein the nonmetal layer is formed by dry plating method.

14. The thin film-laminated polyimide film of the above-mentioned 12 or 13, wherein the nonmetal layer is a high dielectric layer.

15. The thin film-laminated polyimide film of the above-mentioned 12 or 13, wherein the nonmetal layer is a transparent conductive layer.

16. The thin film-laminated polyimide film of the above-mentioned 12 or 13, wherein the nonmetal layer is a photoelectric conversion layer.

17. A flexible printed circuit board comprising the thin film-laminated polyimide film of any one of the above-mentioned 7 - 11, wherein the metal layer is partly removed.

18. A flexible printed circuit board comprising the flexible printed circuit board of the above-mentioned 17 and a semiconductor chip mounted thereon.

19. A semiconductor device comprising the flexible printed circuit board of the above-mentioned 17 and a semiconductor chip mounted thereon.

**Brief Description of the Drawings**

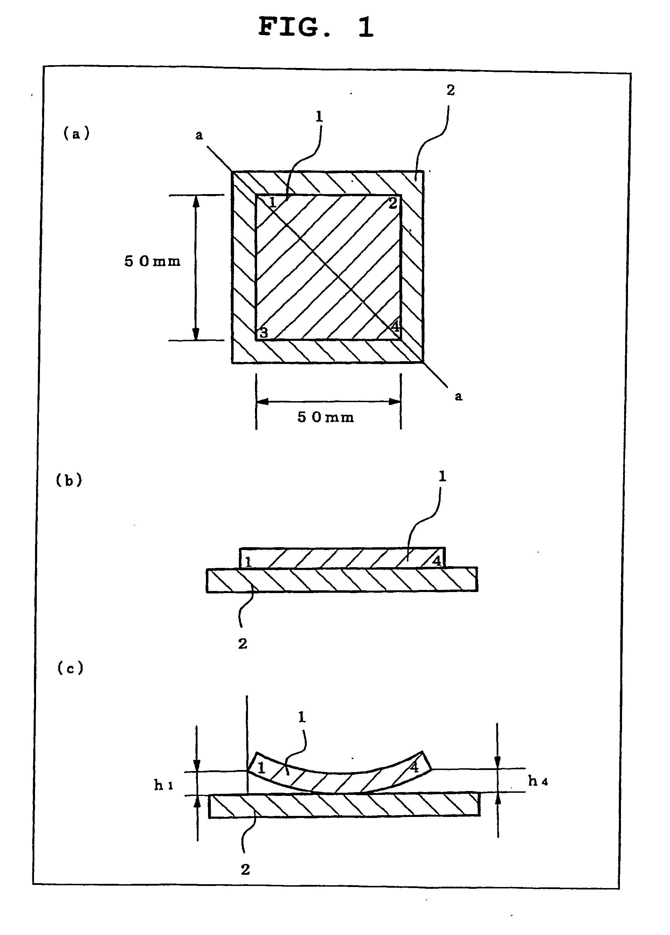

Fig. 1 is a schematic diagram showing the measurement method of the degree of curl of a polyimide elongated film, wherein (a) is a plane view, (b) is a sectional view along a-a of (a) before a hot air treatment, and (c) is a sectional view along a-a of (a) after the hot air treatment. The hatching in (a) was applied to distinguish the regions of a test piece 1 and an alumina·ceramic plate 2.

**Best Mode for Embodying the Invention**

The thin film-laminated polyimide film of the present invention is explained in the following.

The thin film-laminated polyimide film of the present invention comprises a substrate film and a thin film layer formed on at least one surface of the substrate film, which is first characterized in that the substrate film is composed of a polyimide film having a degree of curl after a heat treatment at 300˚C of not more than 10%.

In the present invention, the degree of curl of a film at 300˚C for a polyimide film means the degree of deformation in the thickness direction relative to that in the surface direction of a film after a given heat treatment. Specifically, as shown in Fig. 1, a 50 mmx50 mm test piece 1 is treated with hot air at 300˚C for 10 min, stood still on a flat plane (alumina-ceramic plate 2) to form a concave, an average distance from each top point on the test piece 1 to the flat plane (h1, h2, h3, h4: unit mm) is taken as the amount of curl (mm), and a value shown by the percentage (%) of the amount of curl relative to the distance (35.36 mm) from each top point on the test piece 1 to the center (midpoint of the diagonal line of the test piece 1) is obtained.

In the test piece 1, using 2 points (points at 1/3 and 2/3 of the length of the width) in the width direction at a pitch of 1/5 of the length of the polyimide film as the centers of the test piece, and samples are taken at a total of 10 points (n=10) (when not possible, sampled at the maximum of n points), where the measured value is an average of the 10 (or n) points.

Specifically, it is calculated by the following formula. amount of curl (mm)=(h1+h2+h3+h4)/4 degree of curl (%)=100×(amount of curl)/35.36

In the present invention, the degree of curl of polyimide film after a heat treatment at 300˚C is not more than 10%, more preferably not more than 8%, still more preferably not more than 5%. When it exceeds 10%, the distortion contained in the film is expressed to allow development of curling during production of electronic parts using the polyimide film in the present invention as a substrate (particularly, step of soldering an electronic member to be treated at a high temperature), which in turn causes problems of misalignment in the position of electronic members, delamination and the like, thus possibly interrupting chassis assembly, connector connection and the like.

The substrate film is preferably made of a polyimide obtained by reacting aromatic diamine with aromatic tetracarboxylic acid. As polyimide, one comprising at least a pyromellitic acid residue as an aromatic tetracarboxylic acid residue, and at least a diaminodiphenyl ether residue as an aromatic diamine residue, or comprising at least a biphenyltetracarboxylic acid residue as an aromatic tetracarboxylic acid residue and at least a phenylenediamine residue as an aromatic diamine residue is preferable. It may comprise a pyromellitic acid residue and a biphenyltetracarboxylic acid residue as aromatic tetracarboxylic acid residues and a diaminodiphenyl ether residue and a phenylenediamine residue as aromatic diamine residues. The polyimide may have other aromatic tetracarboxylic acid residue and other aromatic diamine residue than those mentioned above.

In the present invention, the pyromellitic acid residue is a group derived from pyromellitic acid in polyamic acid or polyimide obtained by reacting pyromellitic acid, a functional derivative such as an anhydride thereof or a halide thereof and the like and aromatic diamine. The diaminodiphenyl ether residue is a group derived from diaminodiphenyl ether in polyamic acid or polyimide obtained by reacting diaminodiphenyl ether or various derivatives thereof and aromatic tetracarboxylic acid.

In the present invention, moreover, the biphenyltetracarboxylic acid residue is a group derived from biphenyltetracarboxylic acid in polyamic acid or polyimide obtained by reacting biphenyltetracarboxylic acid, a functional derivative such as an anhydride thereof or a halide thereof and the like and aromatic diamine. The phenylenediamine residue is a group derived from phenylenediamine in polyamic acid or polyimide obtained by reacting phenylenediamine or various derivatives thereof and aromatic tetracarboxylic acid. In the present invention, other aromatic tetracarboxylic acid residue, and other aromatic diamine residue both mean as defined above.

The aforementioned "reaction" is achieved by subjecting aromatic diamine and aromatic tetracarboxylic acid to a ring opening polyaddition reaction and the like in a solvent to give an aromatic polyamic acid solution, then forming a green film from the aromatic polyamic acid solution, which is followed by a heat treatment at a high temperature or dehydrating condensation (imidation).

The aromatic polyamic acid is produced by reacting or polymerizing substantially an equimolar amount of the above-mentioned aromatic tetracarboxylic acids (collectively referring to acid, anhydride, functional derivative, hereinafter to be also referred to as aromatic tetracarboxylic acid) with aromatic diamines (collectively referring to diamine, diamine derivative, hereinafter to be also referred to as aromatic diamine) preferably at a polymerization temperature of 90˚C or below for one min to several days in an inert organic solvent. The aromatic tetracarboxylic acid and aromatic diamine may be directly added in the form of a mixture or a solution to the organic solvent, or the organic solvent may be added to the above-mentioned mixture.

The organic solvent only need to dissolve a part or the whole of the polymerization components, and preferably dissolves a copolyamic acid polymer.

Preferable solvents include N,N-dimethylformamide and N,N-dimethylacetamide. Of this kind of solvents, other useful solvents are N,N-diethylformamide and N,N-diethylacetamide. As other usable solvents, dimethyl sulfoxide, N-methyl-2-pyrrolidone, N-cyclohexyl-2-pyrrolidone and the like can be mentioned. The solvents can be used alone or in a combination of two or more thereof or in a combination with a poor solvent such as benzene, benzonitrile, dioxane and the like.

The amount of the solvent to be used is preferably within the range of 75 - 90 mass % of the aromatic polyamic acid solution. This concentration range affords the optimal molecular weight. It is not necessary to use the aromatic tetracarboxylic acid component and the aromatic diamine component absolutely in an equimolar amount. To adjust the molecular weight, the molar ratio of aromatic tetracarboxylic acid and aromatic diamine (aromatic tetracarboxylic acid/aromatic diamine) within the range of 0.90 - 1.10.

The aromatic polyamic acid solution produced as mentioned above contains 5 - 40 mass %, preferably 10 - 25 mass %, of a polyamic acid polymer.

In the present invention, diaminodiphenyl ether and phenylenediamine are preferable diamines from among the aromatic diamines. Specific examples of diaminodiphenyl ether include 4,4'-diaminodiphenyl ether (DADE), 3,3'-diaminodiphenyl ether and 3,4'-diaminodiphenyl ether. Specific examples of phenylenediamine include p-phenylenediamine, o-phenylenediamine and m-phenylenediamine, and p-phenylenediamine can be preferably used.

In a preferable embodiment, phenylenediamines (preferably p-phenylenediamine) can be used in addition to diaminodiphenyl ether. Moreover, other aromatic diamine may be appropriately selected and used in addition to these aromatic diamines.

In the present invention, pyromellitic acids (pyromellitic acid, dianhydride thereof (PMDA) and lower alcohol esters thereof), and biphenyltetracarboxylic acids (biphenyltetracarboxylic acid, its dianhydride (PMDA) and lower alcohol esters thereof) are preferable from among the aromatic tetracarboxylic acids. As the biphenyltetracarboxylic acids, 3,3',4,4'-biphenyltetracarboxylic acids are preferable.

In a preferable embodiment, biphenyltetracarboxylic acids (preferably 3,3',4,4'-biphenyltetracarboxylic acids) can be used in addition to pyromellitic acid. Moreover, other aromatic tetracarboxylic acids may be appropriately selected and used in addition to these aromatic tetracarboxylic acids.

In the present invention, phenylenediamines are preferably used in a proportion of 50 - 100 mol% relative to the whole aromatic diamines, aromatic diamine other than phenylenediamines is preferably used in a proportion of 0 - 50 mol% relative to the whole aromatic diamines, and diamines other than the two above is preferably used in a proportion of 0 - 50 mol% relative to the whole aromatic diamines. Moreover, diaminodiphenyl ethers may be used in a proportion of 50 - 100 mol% relative to the whole aromatic diamines, phenylenediamines may be used in a proportion of 0 - 50 mol% relative to the whole aromatic diamines, and aromatic diamines other than the two above may be used in a proportion of 0 - 50 mol% relative to the whole aromatic diamines. When the mol% ratio thereof exceeds this range, a heat resistant polyimide film unpreferably shows imbalanced flexibility, rigidity, strength, elastic modulus, water absorption coefficient, hygroscopic expansion coefficient, elongation and the like.

In the present invention, biphenyltetracarboxylic acid anhydride is preferably used in a proportion of 50 - 100 mol% relative to the whole aromatic tetracarboxylic acid, aromatic tetracarboxylic acid other than biphenyltetracarboxylic acids is preferably used in a proportion of 0 - 50 mol% relative to the whole aromatic tetracarboxylic acids, and aromatic tetracarboxylic acids other than the two above is preferably used in a proportion of 0 - 50 mol% relative to the whole aromatic tetracarboxylic acids. Moreover, pyromellitic acids may be used in a proportion of 50 - 100 mol% relative to the whole aromatic tetracarboxylic acids, biphenyltetracarboxylic acids (preferably 3,3',4,4'-biphenyltetracarboxylic acid anhydride) may be used in a proportion of 0 - 50 mol% relative to the whole aromatic tetracarboxylic acids, and aromatic tetracarboxylic acid other than the two above may be used in a proportion of 0 - 50 mol% relative to the whole aromatic tetracarboxylic acids. When the mol% ratio thereof exceeds this range, a heat resistant polyimide film unpreferably shows imbalanced flexibility, rigidity, strength, elongation, elastic modulus, water absorption coefficient, hygroscopic expansion coefficient and the like.

While those usable besides the aforementioned aromatic diamines and aromatic tetracarboxylic acids are not particularly limited, for example, the following can be recited as examples.

Examples of aromatic diamine other than those mentioned above include 5-amino-2-(p-aminophenyl)benzoxazole, 6-amino-2-(p-aminophenyl)benzoxazole, 5-amino-2-(m-aminophenyl)benzoxazole, 6-amino-2-(m-aminophenyl)benzoxazole, 4,4'-bis(3-aminophenoxy)biphenyl, bis[4-(3-aminophenoxy)phenyl]ketone, bis[4-(3-aminophenoxy)phenyl]sulfide, bis[4-(3-aminophenoxy)phenyl]sulfone, 2,2-bis[4-(3-aminophenoxy)phenyl]propane, 2,2-bis[4-(3-aminophenoxy)phenyl]-1,1,1,3,3,3-hexafluoropropane, 3,3'-diaminodiphenylsulfide, 3,3'-diaminodiphenylsulfoxide, 3,4'-diaminodiphenylsulfoxide, 4,4'-diaminodiphenylsulfoxide, 3,3'-diaminodiphenylsulfone, 3,4'-diaminodiphenylsulfone, 4,4'-diaminodiphenylsulfone, 3,3'-diaminobenzophenone, 3,4'-diaminobenzophenone, 4,4'-diaminobenzophenone, 3,3'-diaminodiphenylmethane, 3,4'-diaminodiphenylmethane, 4,4'-diaminodiphenylmethane, bis[4-(4-aminophenoxy)phenyl]methane, 1,1-bis[4-(4-aminophenoxy)phenyl]ethane, 1,2-bis[4-(4-aminophenoxy)phenyl]ethane, 1,1-bis[4-(4-aminophenoxy)phenyl]propane, 1,2-bis[4-(4-aminophenoxy)phenyl]propane, 1,3-bis[4-(4-aminophenoxy)phenyl]propane, 2,2-bis[4-(4-aminophenoxy)phenyl]propane and the like.

Examples thereof include aromatic diamine wherein a part or the whole of hydrogen atom on the aromatic ring in the above-mentioned aromatic diamine is substituted by halogen atom, an alkyl group or alkoxyl group having 1 to 3 carbon atoms, a cyano group, or a halogenated alkyl group or alkoxyl group having 1 to 3 carbon atoms, wherein a part or the whole of hydrogen atom of alkyl group or alkoxyl group is substituted by halogen atom, and the like.

Examples of aromatic tetracarboxylic acids other than those mentioned above include bisphenol A bis(trimellitic acid monoester acid anhydride), 2,2-bis[4-(3,4-dicarboxyphenoxy)phenyl]propanoic acid anhydride, 3,3',4,4'-benzophenonetetracarboxylic acid dianhydride, 3,3',4,4'-diphenylsulfonetetracarboxylic acid dianhydride, 1,4,5,8-naphthalenetetracarboxylic acid dianhydride, 2,3,6,7-naphthalenetetracarboxylic acid dianhydride, 4,4'-oxydiphthalic acid anhydride, 3,3',4,4'-dimethyldiphenylsilane tetracarboxylic acid dianhydride, 1,2,3,4-furantetracarboxylic acid dianhydride, 4,4'-bis(3,4-dicarboxyphenoxy)diphenylpropanoic acid dianhydride, 4,4'-hexafluoroisopropylidenediphthalic acid anhydride and the like.

In the present invention, a polyimide film is produced by forming a green film from an aromatic polyamic acid solution, followed by a high temperature heat treatment or dehydrating condensation (imidation).

In a preferable production example, a polyimide precursor film (green film) is produced, which satisfies the imidation rate $IM_A$ of one surface side (surface A side) and imidation rate $IM_B$ of the other surface side (surface B side) of the polyimide precursor film (green film), as shown by the following formula, and the polyimide precursor film (green film) is imidated.

$$\text{Formula 1;} \quad |IM_A - IM_B| \leqq 5$$

In the present invention, the imidation rate of the green film is measured by the following method.

<Measurement method of imidation rate>

A 2 cm×2 cm measurement target film is taken, the measurement target surface is closely adhered to ATR crystal, and set on an IR measurement apparatus. The absorbance at the following characteristic wavelength is measured and the imidation rate of the measured film target surface is obtained by the following formula.

As the imide characteristic wavelength, around 1778 cm$^{-1}$ is employed and the absorbance of the measured surface at the wavelength is taken as $\lambda_{1778}$. As the standard, the aromatic ring characteristic wavelength of around 1478 cm$^{-1}$ is employed and the absorbance of the measured surface at the wavelength is taken as $\lambda_{1478}$.

apparatus; FT-IR FTS60A/896 (Digilab Japan Co., Ltd.) measurement condition; one reflection ATR attachment (SILVER GATE)

    ATR crystal Ge
    incident angle 45˚
    detector DTGS
    resolution 4 cm$^{-1}$
    accumulation time 128 times
    Formula 2; $IM = \{I\lambda / I(450)\} \times 100$

In Formula 2, $I\lambda = (\lambda_{1778}/\lambda_{1478})$, and $I(450)$ is the value of $(\lambda_{1778}/\lambda_{1478})$ when a polyimide precursor film having the same composition is imidated by thermal cyclization at 450˚C for 15 min and measured in the same manner.

These values can be measured from formula 2 using the imidation rate IM of surface A as $IM_A$, and that of surface B as $IM_B$. The difference between $IM_A$ and $IM_B$ is shown in an absolute value.

The measurement points are any points in the longitudinal direction of the film, which are two points in the width direction (points at 1/3 and 2/3 of beam length), and the measured value is an average of the two points.

While the method for producing the above-mentioned particular green film is not particularly limited, a preferable example is the following method.

When the green film is dried to the degree it acquires self-supporting property, the direction of evaporation of the solvent is limited to the surface in contact with the air. As a result, the imidation rate of the surface of the green film in contact with the air tends to become smaller than that of the surface in contact with the support. To obtain a polyimide film showing a small difference in the orientation between the front and the back surfaces, the difference in the imidation rate between the front and the back surfaces of the green film needs to be within a tolerance range. The imidation rate of the green film becomes high when a thermal energy is applied more than necessary when the amount of solvent is high and the degree of freedom of polyamic acid molecule is high. To suppress the difference in the imidation rate between the front and the back to a tolerance range, it is necessary to remove the solvent as uniformly as possible from the front and the back with the minimum necessary heating. Thus, the drying conditions for obtaining a self-supporting green film by coating a support with a polyamic acid solution and drying same need to be controlled while managing the amount of heat to be added, evaporation rate of solvent, difference in the solvent amount between the front and the back and the like. By such control, a green film wherein the imidation rates of the front and the back surfaces are within a given range and the difference between them is within a given range can be obtained.

The difference in the imidation rate between the front and the back surfaces of the green film is preferably not more than 5, more preferably not more than 4, still more preferably not more than 3. Moreover, the imidation rate of both the front and the back is preferably controlled to fall within the range of 1 - 15.

When the difference in the imidation rate between the front and the back surfaces of the green film exceeds 5, the distortion potentially present within the film remains, and curling is developed after a heat treatment at 300°C, affording a polyimide elongated film unsuitable for production.

In addition, a green film wherein the imidation rates of the front and the back surfaces are within a given range and the difference between them is within a given range can be obtained by controlling the residual solvent amount relative to the total mass of the green film after drying, when the coated film is dried to the extent that the green film acquires self-supporting property. To be specific, the residual solvent amount relative to the total mass of the green film after drying is essentially preferably 25 - 50 mass %, more preferably 35 - 50 mass %. When the residual solvent amount is lower than 25 mass %, the imidation rate on one side of the green film becomes relatively too high, making it difficult to obtain a green film showing a small difference in the imidation rate between the front and the back surfaces, but also the green film tends to be brittle due to the lower molecular weight. When it exceeds 50 mass %, the self-supporting property becomes insufficient, making transport of the film difficult.

To achieve such conditions, a dryer such as hot air, hot nitrogen, far-infrared radiation, high frequency induction heating and the like can be used. As the drying conditions, the following temperature control is required.

When hot air drying is performed, during drying of the coated film to the extent that the green film has self-supporting property, an operation allowing uniform volatilization of the solvent from the entirety of the coated film by prolonging the constant rate of drying conditions is preferable, so that the imidation rate of the front and the back surfaces of the green film and the difference thereof can be set within the given ranges. The constant rate of drying is a drying region where the coated film surface is made of a free liquid level and volatilization of the solvent is controlled by the movement of substance in the outside world. Under the drying conditions where the coated film surface is solidified by drying, and solvent diffusion in the coated film becomes a rate determining factor, the property of the front and the back easily becomes different. While such preferable drying state varies depending on the kind and thickness of the support, the coated film is dried under the conditions of temperature setting and air amount setting where the ambient temperature of the opposite side (opposite surface side of the coated film surface) to the upper side (coated film surface side) of the coated film (green film) on a support is generally higher by 1 - 55°C than the ambient temperature of the upper side (coated film surface side) of the coated film (green film) on a support. In the explanation of the ambient temperature, the direction heading from the coated film toward the support is defined as a lower direction, and the opposite is defined as an upper direction. Such description of the upper and lower directions aims at a simply expression of the positions of the regions to be noted, and does not intend to specify the absolute direction of the coated film in the actual production.

The "ambient temperature of the coated film surface side" is a temperature of the region from the surface of the coated film to 30 mm above the coated film surface (generally a space), and the ambient temperature of the coated film surface can be determined by measuring the temperature with a thermocouple and the like at the position 5 - 30 mm away in the upward direction from the coated film.

The "ambient temperature of the opposite side" is a temperature of the region from immediately beneath the coated film (support) to 30 mm below the coated film (often containing support and a lower part of the support), and the ambient temperature of the opposite side can be determined by measuring the temperature with a thermocouple and the like at the position 5 - 30 mm away in the downward direction from the coated film.

When the ambient temperature of the opposite surface side is set higher by 1 - 55˚C than that of the coated film surface side during drying, a high quality film can be obtained even when the drying temperature itself is made higher to increase the drying rate of the coated film. When the ambient temperature of the opposite surface side is lower than that of the coated film surface side, or the difference in the ambient temperature of the coated film surface side from that on the opposite side is less than 1˚C, the vicinity of the coated film surface is dried earlier to form a film like a "lid", which prevents transpiration of the solvent to be evaporated from the vicinity of the support, producing a fear of inducing a distortion in the inside structure of the film. It is economically disadvantageous and undesirable for the apparatus that the ambient temperature of the opposite side is set higher than that of the coated film surface side and the temperature difference is set greater than 55˚C. Preferably, during drying, the ambient temperature of the aforementioned opposite side is preferably set higher by 5 - 55˚C, more preferably 10 - 50˚C, further preferably 15 - 45˚C, than that of the coated film surface side.

The ambient temperature of the coated film surface side is specifically preferably 80 - 105˚C, more preferably 90 - 105˚C.

The ambient temperature on the opposite side is specifically preferably 85˚C - 105˚C, more preferably 100 - 105˚C.

The above-mentioned setting of the ambient temperature may be performed throughout the entire drying steps of the coated film, or in a part of the drying steps of the coated film. When the coated film is dried in a continuous dryer such as a tunnel furnace and the like, the aforementioned ambient temperature only needs to be set for the length of preferably 10 - 100%, more preferably 15 - 100%, of a drying effective length.

The drying time is 10 - 90 min, desirably 15 - 45 min, in total.

The green film after the drying step is then subjected to an imidation step, which may be performed by any of inline and offline methods.

When an offline is employed, the green film is once wound up. In this case, the film is wound around a tubular object with the green film facing inside (support being the outside) to reduce curling.

In any event, the film is preferably transported or wound in such a manner that the radius of curvature will not become 30 mm or below.

In the present invention, the "precursor film (green film)" is a film wherein the amount of the residual solvent is about 50 mass % or below, though subject to change depending on the thickness and molecular weight, which is specifically a film obtained by drying the coated film on the support, and refers to a film between release from the support and heating to not less than 50˚C. When the atmosphere for releasing is already not less than 50˚C, it refers to a film between immediately after release and heating to not less than release ambient temperature+30˚C.

By imidation of a green film obtained by such method, wherein the imidation rate of the front and the back surfaces and the difference therein has been controlled to fall within given ranges under given conditions, a polyimide elongated film having a low degree of curl after a heat treatment at 300˚C of the present invention can be obtained. The elongated film here means a film having a length of not less than 30 m, preferably not less than 100 m.

As specific imidation method therefor, a conventionally-known imidation reaction can be appropriately used. For example, a method comprising subjecting a polyamic acid solution free of a cyclization catalyst and a dehydrating agent to a heat treatment to carry out an imidation reaction (what is called a thermal cyclization method) and a chemical cyclization method wherein a cyclization catalyst and a dehydrating agent are added to a polyamic acid solution and an imidation reaction is performed by the action of the above-mentioned cyclization catalyst and dehydrating agent can be mentioned, of which the thermal cyclization method is preferable for affording a polyimide elongated film showing a degree of curl after a heat treatment at 300˚C of 10% or below.

The maximum temperature of heating by the thermal cyclization method is, for example, 100 - 500˚C, preferably 200 - 480˚C. When the maximum heating temperature is lower than this range, sufficient cyclization becomes difficult, and when it is higher than this range, degradation proceeds and the film tends to be brittle. A more preferable embodiment is a two-step heat treatment including a treatment at 150 - 250˚C for 3 - 20 min, followed by a treatment at 350 - 500˚C for 3 - 20 min.

In the chemical cyclization method, a polyamic acid solution is applied to a support, an imidation reaction is partially carried out to form a film having self-supporting property, and the imidation is completed by heating. In this case, the conditions for partial progress of imidation reaction include a heat treatment preferably at 100 - 200˚C for 3 - 20 min, and the conditions for complete imidation reaction include a heat treatment preferably at 200 - 400˚C for 3 - 20 min.

The both ends of the film are held with a pin tenter or clip during the aforementioned drying treatment and imidation treatment. During this operation, the tension in the width direction and the longitudinal direction of the film is desirably maintained as uniformly as possible to retain the uniformity of the film.

Specifically, immediately before subjecting the film to a pin tenter, the both ends of the film may be pressed with a brush to uniformly stick pins into the film. A rigid, heat-resistant fiber brush is desirable, and a high strength high elastic modulus monofilament can be used.

By satisfying the aforementioned conditions (temperature, time, tension) for the imidation treatment, the development of the orientation distortion in the film inside (front and back, flat plane direction) can be suppressed.

The timing of the addition of a cyclization catalyst to a polyamic acid solution is not particularly limited and it may be added in advance before a polymerization reaction to afford polyamic acid. Specific examples of the cyclization catalyst include aliphatic tertiary amines such as trimethylamine, triethylamine and the like, heterocyclic tertiary amine such as isoquinoline, pyridine, betapicoline and the like, and the like. Of these, at least one kind of amine selected from heterocyclic tertiary amines is preferable. While the amount of the cyclization catalyst to be used relative to 1 mol of polyamic acid is not particularly limited, it is preferably 0.5 - 8 mol.

The timing of the addition of a dehydrating agent to a polyamic acid solution is not particularly limited either, and it may be added in advance before a polymerization reaction to afford polyamic acid. Specific examples of the dehydrating agent include aliphatic carboxylic acid anhydrides such as acetic anhydride, propionic anhydride, butyric anhydride and the like, aromatic carboxylic acid anhydrides such as benzoic anhydride and the like, and the like. Of these, acetic anhydride, benzoic anhydride and a mixture thereof are preferable. While the amount of the dehydrating agent to be used per 1 mol of polyamic acid is not particularly limited, it is preferably 0.1 - 4 mol. When a dehydrating agent is to be used, a gelling retardant such as acetylacetone and the like may be used in combination.

While the thickness of the polyimide elongated film is not particularly limited, it is generally 1 - 150 $\mu$m, preferably 3 - 50 $\mu$m, in consideration of its use for an electron substrate for a base substrate for the below-mentioned printed circuit substrate and the like. The thickness can be easily controlled by changing the amount of the polyamic acid solution to be applied to the support and the concentration of the polyamic acid solution.

In the polyimide elongated film obtained by the above-mentioned production method, a polyimide elongated film having a smaller degree of curl can be preferably obtained by winding the film around a tubular object with surface A facing inside, which tends to show a greater absorption ratio than surface B. For winding the film around a tubular object with surface A facing inside, the radius of curvature thereof is preferably within the range of from 30 mm to 600 mm. When the radius of curvature exceeds this range, the degree of curl of the polyimide elongated film sometimes becomes high.

The aforementioned absorption ratio means an orientation degree of the imide ring surface of polyimide molecules, which are in the height of about 3 $\mu$m down from the film surface (or backside, hereinafter the same), relative to the film surface. Specifically, polarized ATR measurement of the film surface is performed by FT-IR (measurement apparatus: FTS-60A/896 manufactured by Digilab, etc.) under the conditions of one-time reflection ATR attachment, golden gate MkII (manufactured by SPECAC LIMITED), IRE diamond, incident angle 45°, resolution 4 cm$^{-1}$ and accumulation time 128 times, the absorption coefficients (Kx, Ky and Kz) of each direction at the peak (aromatic ring vibration) appearing near 1480 cm$^{-1}$ are determined and the ratio is defined by the following formula. absorption ratio=(Kx+Ky)/2xKz wherein Kx shows an absorption coefficient in the MD direction, Ky shows an absorption coefficient in the TD direction, and Kz shows an absorption coefficient in the thickness direction.

The measurement position is an optional position in the longitudinal direction of the film. In this case, two points in the width direction (points 1/3 and 2/3 of the beam length), and the measured value is an average of the two points.

In the present invention, surface A refers to the surface having a greater absorption ratio, and surface B refers to the surface having a smaller absorption ratio.

Furthermore, the winding tension is desirably set to not less than 100 N, preferably not less than 150 N and not more than 500 N.

Accordingly, a preferable embodiment for improving the curl when winding a polyimide elongated film around a roll may be a method comprising winding with surface A facing inside, wherein the radius of curvature is comparatively large and is 30 - 600 mm, preferably 80 - 300 mm, and further, the winding tension is not less than 100 N.

To reduce the difference in the property of the wound film between the winding core side (roll inner layer side) and the outward winding side (roll outer layer side) as much as possible, it is desirable to increase the winding tension as the radius of curvature of the film increases (making the winding tension on the winding core side smaller and that of the outward winding side greater).

Furthermore, when the imidation of the green film is to be performed offline, a method comprising winding the green film facing inside (support being outside) can be employed.

The polyimide elongated film is treated with heat in the drying step and imidation step of the green film. In this event, when the width direction of the film has treatment unevenness, the property changes in the width direction of the film, which in turn causes curling.

In the present invention, therefore, the difference in the ambient temperature in the width direction in a dryer is desirably controlled to central temperature $\pm$ within 5°C, preferably $\pm$ within 3°C, more preferably $\pm$ within 2°C.

As used herein, the ambient temperature means a temperature measured using a thermocouple, thermolabel and the like at positions which are at the same distance (5 mm - 30 mm) away from the surface of the support. In the present invention, moreover, it is preferable to set 8 to 64 points of temperature detection end in the width direction.

Particularly, the interval between the neighboring detection ends in the width direction is preferably set to about 5 cm - 10 cm. As the detection end, a known thermocouple such as alumel-chromel and the like can be used.

In the present invention, the ambient temperature on the opposite side can be set 5 - 55˚C higher than that on the coated surface side. Also in this case, it is essential to fall within the range of $\pm$5˚C from the central temperature of the temperatures on each side of the support. The central temperature is the arithmetic mean value of the centigrade temperatures measured at respective detection ends, and when the temperatures measured at respective detection ends in the width direction orthogonal to the running direction of the support are within the range of +5˚C, it is within the range calculated based on the numerical value of the central value.

The polyimide elongated film produced under such conditions is extremely superior in the planarity at a high temperature and shows a degree of curl of 10% or below as measured under the aforementioned conditions.

The slip property of the polyimide film as a substrate in the present invention is preferably improved by adding a lubricant to polyimide and the like to form ultrafine concaves and convexes on the film surface.

As the lubricant, inorganic and organic fine particles having an average particle size of about 0.03 - 3 $\mu$m can be used. Specific examples thereof include titanium oxide, alumina, silica, calcium carbonate, calcium phosphate, calcium hydrogenphosphate, calcium pyrophosphate, magnesium oxide, calcium oxide, clay mineral and the like.

The thin film-laminated polyimide film of the present invention can be processed into a metallized polyimide film. The metallized polyimide film is basically made of a polyimide containing an aromatic diamine residue and an aromatic tetracarboxylic acid residue, and is constituted by a polyimide film (IF) having a degree of curl after a heat treatment at 300˚C of not more than 10% as a substrate, a metal underlayer (UM) formed by dry plating method when necessary, a conductive thin film layer (dM) constituted by a metal thin film layer always formed by dry plating method, and a metal thick film layer (DM) appropriately formed by dry plating method on the conductive thin film layer. As the polyimide, one having at least a pyromellitic acid residue and a diaminodiphenyl ether residue, or one having at least a biphenyltetracarboxylic acid residue and a phenylenediamine residue is preferable, which may have a pyromellitic acid residue, a biphenyltetracarboxylic acid residue, a diaminodiphenyl ether residue and a phenylenediamine residue. As used herein, the metal thin film layer means a metal layer formed by a vacuum thin film technique such as vapor deposition, sputtering and the like, and the metal thick film layer means a metal layer formed by a thick film technique, i.e., wet plating technique or calcination thick film technique.

When a conductive metal layer (conductive thin film layer) is formed on the surface of a polyimide film as a substrate, a layer of nickel-chrome alloy is preferably first formed as an underlayer by sputtering, wherein the thickness of the underlayer is 20 - 2000 Å, preferably 40 - 1000 Å, more preferably 80 - 500 Å. When the thickness of the layer of nickel-chrome alloy formed by sputtering is less than 20 Å, the adhesiveness with the substrate film is not sufficient, and when it exceeds 2000 Å, abnormal precipitation of metal due to electroless plating and the like to be applied thereafter occurs markedly. The chrome content of the nickel-chrome alloy is desirably 1 - 10 mass %, more preferably 2 - 8 mass %, still more preferably 3 - 6 mass %. When the chrome content is less than 1 mass %, the migration resistance is not improved. Even if it exceeds 10 mass %, a migration resistance-improving effect is almost the same. Conversely, the conductive property of the metal thin film layer and the like is inhibited, and problems of, for example, increased residual copper during pattern formation occur. The conducted layer, for example, a copper layer, to be formed on a layer of nickel-chrome alloy formed by sputtering preferably has a suitable thickness of 1 - 12 $\mu$m, further 1 - 9 $\mu$m, still further about 2 - 5 $\mu$m. The underlayer here means a metal layer to be in direct contact with a polyimide layer, which affords an anchor effect by its suitable hardness as well as blocks the metal (e.g., copper) constituting the metal thin film layer from diffusing into the polyimide layer.

In the present invention, it is preferable to subject the surface of a polyimide film made of a polyimide containing at least a biphenyltetracarboxylic acid residue and a phenylenediamine residue, which has a degree of curl after a heat treatment at 300˚C of not more than 10%, to a plasma treatment, attach, for example, a nickel-chrome alloy as a metal underlayer by sputtering in a thickness of 20 - 2000 Å, attach a metal thin film layer of, for example, copper and the like by a dry plating method such as a sputtering method and/or vapor deposition method and the like, further form a metal thick film layer by electrolytic plating, electroless plating and the like, and apply a heat treatment at 200 - 350˚C.

The surface of the polyimide film is preferably treated by a plasma treatment, wherein the plasma is an inert gas plasma, and as the inert gas, nitrogen gas, Ne, Ar, Kr or Xe is used. The method of generating plasma is not particularly limited, and an inert gas is introduced into a plasma generator to allow production of plasma. The method of plasma treatment is not particularly limited, and a plasma treatment apparatus used when a metal layer is formed on a substrate film may be used. The time necessary for the plasma treatment is not particularly limited, but is generally 1 sec - 30 min, preferably 10 sec - 10 min. The frequency and the output of plasma during plasma treatment, and the gas pressure and the treatment temperature for plasma generation are particularly limited as long as they are within the range handlable by a plasma treatment apparatus. The frequency is generally 13.56 MHz, the output is generally 50 W - 1000 W, the gas pressure is generally 0.01 Pa - 10 Pa, and the temperature is generally 20˚C - 250˚C, preferably 20˚C - 180˚C. When the output is too high, the surface of the substrate film may be cracked. When the gas pressure is too high, the smoothness of the surface of polyimide film (electric insulating layer) may be degraded.

Then, for example, a nickel-chrome alloy as a metal underlayer is attached to the treated surface by sputtering, whereby a 20 - 2000Å thick nickel-chrome alloy sputtering layer is formed. The sputtering conditions may be any. For the nickel-chrome alloy sputtering layer, a method using a nickel-chrome alloy target, a method comprising dual simultaneous sputtering, a method comprising independently sputtering nickel and chrome, and diffusing them in a later step, and the like can be used.

Now, a metal thin film layer is formed. The metal thin film layer is a conductive layer, wherein the metal thin film layer is formed by what is called a dry plating method such as sputtering method, vapor deposition method, ion plating method, CVD method and the like, with preference given to sputtering method and vapor deposition method.

The method of sputtering as a preferable method for the formation of a metal underlayer or a metal thin film layer is not particularly limited, and direct dipole sputtering, high frequency sputtering, magnetron sputtering, opposing target sputtering, ECR sputtering, bias sputtering, plasma control sputtering, multitarget sputtering and the like can be used. Of these, direct dipole sputtering and high frequency sputtering are preferable. The output during sputtering treatment, and the gas pressure and the treatment temperature for plasma generation are particularly limited as long as they are within the range handlable by a sputtering treatment apparatus. The output is generally 10 W - 1000 W, the gas pressure is generally 0.01 Pa - 10 Pa, and the temperature is generally 20˚C - 250˚C, preferably 20˚C - 180˚C. The film-forming rate is 0.1 Å/sec - 1000 Å/sec, preferably 1 Å/sec - 100 Å/sec. When the film-forming rate is too high, the formed metal thin film layer may be cracked. When the gas pressure is too high, the adhesion may be degraded.

In the present invention, a method wherein, after a nickel-chrome alloy sputtering layer as an underlayer, a metal thin film layer with a thickness of about 0.1 - 3 $\mu$m, for example, a copper layer, as a conductive layer is formed by any of the dry plating such as sputtering method, vapor deposition method and the like, and the thickness of the copper layer as a metal thick film layer (thick film layer) is further added by wet plating such as electrolytic plating method and the like can be preferably used.

As the metal for a metal underlayer, a metal thin film layer and a metal thick film layer in the present invention, silver, copper, gold, platinum, rhodium, nickel, aluminum, iron, chrome, zinc, tin, brass, white copper, bronze, monel, tin-lead solder, tin-copper solder, tin-silver solder and the like may be used alone or as an alloy thereof. Use of a nickel-chrome alloy as the metal underlayer and use of copper as a metal thin film layer and a metal thick film layer are preferable embodiments for balancing property and economic aspect.

In the dry plating, the film is maintained at 100˚C - 400˚C, preferably 150˚C - 350˚C, during vapor deposition, whereby the adhesiveness between the metal underlayer and the metal thin film layer (e.g., copper thin film layer) becomes strong. It is presumed in this step that a part of the underalloy and the vapor deposited metal are mutually diffused, and a composition-gradient region is formed in the interface.

For formation of a copper thick film layer preferably used as the metal thick film layer in the present invention, electrolytic plating and electroless plating can be used. As the electrolytic plating method, copper pyrophosphate plating and copper sulfate plating can be preferably used.

In a preferable embodiment of the present invention, a metallized polyimide film which is a complex of a polyimide film obtained by the above-mentioned method and a metal is further heat treated at 200 - 350˚C. This heat treatment is preferably performed at 220 - 330˚C, more preferably 240 - 310˚C. Due to the heat treatment, distortion possessed by a substrate film and distortion generated during production process of a metallized polyimide film can be reduced, and the effect of the invention can be expressed still more effectively, and the durability and reliability of the aforementioned semiconductor package and the like can be improved. A temperature of less than 200˚C shows a small effect of reducing the distortion, and a temperature exceeding 350˚C is not preferable because the polyimide film of the substrate is deteriorated.

The thus-obtained metallized polyimide film of the present invention is subjected to the steps for application of a photoresist to a conductive metal thin film layer and/or a metal thick film layer side, drying, exposure, development, etching and photoresist release by a conventional method to form a wiring circuit pattern, and further to application of solder resist, curing and electroless tin plating as necessary, whereby a flexible printed circuit board, a multi-layer printed circuit board comprising multiple layers thereof, or a printed circuit board containing a semiconductor chip directly mounted thereon is obtained.

A coated film of an inorganic material such as a simple metal, metal oxide and the like may be formed on the surface of a metal thin film layer and/or a metal thick film layer (copper layer) used in the present invention. In addition, the surface of a metal thin film layer and/or a metal thick film layer may be subjected to a treatment with a coupling agent (aminosilane, epoxysilane and the like), a sandblast treatment, a holing treatment, a corona treatment, a plasma treatment, an etching treatment and the like.

As mentioned in the foregoing, a metallized polyimide film using a polyimide film having particular property as a substrate is superior in the planarity and when processed, for example, into a printed circuit board and the like, it is free of warpage and distortion, showing superior flat plane retention as well as superior adhesion of a metal thin film layer. Since uniform laminate processing is possible even when multiple layers are formed, the film shows small warpage and deformation and is useful as a substrate for mounting display driver, high-speed arithmetic device, graphic controller, high capacity memory element and the like requiring particularly highly dense, ultrafine wiring.

The film is further useful for a product using a film exposed to a high temperature as a substrate, wherein various metal thin film layers are formed by dry plating such as sputtering, ion plating or vapor deposition, and is useful as a decoration film with a thin film of aluminum and the like, a reflection film with a thin film of aluminum and the like, a reflection preventive film with a metal multi-layer thin film, a characteristic wavelength permeation film with a metal multi-layer thin film and the like.

The thin film-laminated polyimide film of the present invention is basically made of a polyimide containing an aromatic diamine and an aromatic tetracarboxylic acid, and may be constituted by a polyimide film (IF) having a degree of curl after a heat treatment at 300˚C of not more than 10% as a substrate, a nonmetal thin film layer (dM) formed by dry plating method and a layer (DM) appropriately formed on and under the nonmetal thin film layer by dry plating method. As the polyimide, one containing at least a pyromellitic acid residue and a diaminodiphenyl ether residue, or one containing at least a biphenyltetracarboxylic acid residue and a phenylenediamine residue is preferable, and one containing a pyromellitic acid residue, a biphenyltetracarboxylic acid residue, a diaminodiphenyl ether residue and a phenylenediamine residue may be used.

In the present invention, the nonmetal thin film layer (dM) may be constituted with plural layers rather a single layer, wherein at least one layer of the plural layers is a nonmetal layer and the constitution may be IF/nonmetal layer, IF/nonmetal layer/metal layer, IF/nonmetal layer/nonmetal layer/metal layer, IF/metal layer/nonmetal layer/metal layer, IF/metal layer/nonmetal layer/nonmetal layer/metal layer, and the like.

Moreover, the layer (DM) to be appropriately formed on and under the nonmetal thin film layer to be further formed on the aforementioned IF/dM may be formed by a dry plating, or a method other than dry plating.

In the present invention, the nonmetal refers to compounds of carbon, silicon, metal oxide and the like, organic compounds and the like, or one containing them as a main component, which may be used alone or in a mixture and may contain an additive component, but is always formed by dry plating method.

Specific examples of nonmetal include graphite, amorphous carbon, amorphous silicon, polycrystalline silicon, $In_2O_3$, $SnO_2$, ZnO, $Cd_2SnO_4$, ITO ($In_2O_3$ added with Sn) and the like, further Rochelle salt ferroelectric materials such as Rochelle salt, lithium ammonium tartrate, lithium thallium tartrate and the like, alkaline dihydrogen phosphate (arsenate) ferroelectric materials such as potassium dihydrogen phosphate, potassium dihydrogen arsenate, rubidium dihydrogen phosphate, rubidium dihydrogen arsenate, cesium dihydrogen arsenate, cesium dihydrogen phosphate, and the like, perovskite ferroelectric materials such as barium titanate, lead titanate, sodium niobate, potassium niobate, sodium tantalate, potassium tantalate, lanthanum gallate and the like, modified perovskite ferroelectric materials such as tungsten trioxide and the like, pyrochlorite ferroelectric materials such as cadmium niobate, lead pyroniobate and the like, ilmenite ferroelectric materials such as cadmium titanate, cobalt titanate, iron titanate, lithium niobate, magnesium titanate, manganese titanate, nickel titanate, lithium titanate and the like, guanidine ferroelectric materials such as guanidine·aluminum· sulfate hexahydrate, guanidine·gallium·sulfate, guanidine·chrome·sulfate, guanidine·vanadium·sulfate, guanidine·chrome· selenate, guanidine·aluminum·selenate, guanidine·gallium· selenate and the like, glycine ferroelectric materials such as triglycine-sulfate, triglycine-fluoberylate, triglycine. selenate, diglycine nitrate salt, diglycine manganese chloride dihydrate, glycine silver nitrate and the like, other compounds such as $Pb_2MgWO_3$, $Pb_3Fe_2WO_6$, $Pb_2FeTaO_6$, $K3Li_2Nb_5O_{15}$, $Ba_2NaNb_5O_{15}$, $Pb_2KNb_5O_{15}$, $Pb_5Ge_3O_{11}$, $Gd_2(MoO_4)_3$, methylammonium·aluminum sulfate·dodecahydrate, urea chrome sulfate, ammonium sulfate, ammonium sulfate·cadmium, lithium·hydrazine·sulfate, ammonium hydrogensulfate, lithium·hydroxide·selenic acid, ammonium monochromeacetate, dicalcium·strontium·propionic acid, urea, ammonium fluorinated beryllium acid, etc., further mixtures of inorganic ferroelectric materials such as perovskite, pyrochlorite, ilmenite and the like, ceramic ferroelectric materials made of solid solutions, specifically, PZT {lead titanate/lead zirconate solid solution:$Pb(Zr, Ti)O_3$}, PLT {lead titanate/lanthanum titanate solid solution:$(Pb,La)TiO_3$}, PLZT {$(Pb,La)(Zr,Ti)O_3$}, lead niobate/barium niobate solid solution, strontium niobate/barium niobate solid solution, PTS {$Pb(Ti,Sn)O_3$}, PST {$(Pb,Sr)TiO_3$}, BPT {$(Ba,Pb)TiO_3$}, BST {$(Ba,Sr)TiO_3$}, BMT {$(Ba,Mg)TiO_3$}, BCT {$(Ba,Ca)TiO_3$} and the like.

The layer (DM) to be appropriately formed on the nonmetal thin film layer in the present invention may be a color material, polymer compound or the aforementioned nonmetal or metal, and the method of formation thereof is not limited.

In the present invention, the surface of a polyimide film made of a polyimide containing at least a biphenyltetracarboxylic acid residue and a phenylenediamine residue, which shows a degree of curl after a heat treatment at 300˚C of not more than 10%, is subjected to a plasma treatment, a thin film of nonmetal and the like is attached by dry plating such as a sputtering method, a vapor deposition method and the like, and, before and after the attachment, a layer (DM) is appropriately formed on and under the nonmetal thin film by various methods. Alternatively, the surface of a polyimide film made of a polyimide containing at least a pyromellitic acid residue and a diaminodiphenyl ether residue, which shows a degree of curl after a heat treatment at 300°C of not more than 10%, is subjected to a plasma treatment, a thin film of nonmetal and the like is attached by dry plating such as a sputtering method, a vapor deposition method and the like, and, before and after the attachment, a layer (DM) is appropriately formed on the upper surface and/or the lower surface of the nonmetal thin film by various methods.

When the surface of the polyimide film is treated by a plasma treatment, development method and treatment method of plasma are as explained above.

A nonmetal thin film (layer) is formed by what is called a dry plating method such as sputtering method, vapor deposition method, ion plating method, CVD method and the like, with preference given to a sputtering method and a vapor deposition method.

The method of sputtering as a preferable method for formation of a nonmetal thin film is not particularly limited, and direct dipole sputtering, high frequency sputtering, magnetron sputtering, opposing target sputtering, ECR sputtering, bias sputtering, plasma control sputtering, multitarget sputtering and the like can be used. Of these, direct dipole sputtering or high frequency sputtering is preferable.

The output during sputtering treatment, and the gas pressure and the treatment temperature for plasma generation are particularly limited as long as they are within the range handlable by a sputtering apparatus. The output is generally 10 W - 1000 W, the gas pressure is generally 0.01 Pa - 10 Pa, and the temperature is generally 20°C - 250°C, preferably 20°C - 180°C. The film-forming rate is 0.1 Å/sec - 1000 Å/sec, preferably 1 Å/sec - 100 Å/sec. When the film-forming rate is too high, the formed thin film may be cracked. When the gas pressure is too high, the adhesion may be degraded.

While the material of the metal layer is not particularly limited, silver, copper, gold, platinum, rhodium, nickel, aluminum, iron, zinc, tin, brass, white copper, bronze, monel, tin-lead solder, tin-copper solder, tin-silver solder and the like are used.

In the dry plating such as sputtering method and vapor deposition method, the polyimide film substrate is maintained at 100°C - 400°C, preferably 150°C - 350°C, whereby the adhesiveness between the film and the thin film becomes stronger.

In the present invention, the thin film-laminated polyimide film obtained by the above-mentioned method, which is a complex of a polyimide film and a nonmetal thin film may be further heat-treated at 200 - 350°C. It is preferably 220 - 330°C, more preferably 240 - 310°C.

By the heat treatment, the distortion possessed by a substrate film and distortion produced during the thin film forming process of the thin film-laminated polyimide film are reduced, and the effect of the invention can be more effectively expressed, and the quality, durability and reliability of a functional material can be improved. A temperature of less than 200°C shows a small effect of reducing the distortion, and a temperature exceeding 350°C is not preferable because the polyimide film of the substrate is deteriorated.

In the present invention, a thin film-laminated polyimide film wherein the nonmetal thin film is a high dielectric layer is an example of a preferable embodiment. The high dielectric layer is not limited to the following high dielectric layer. As used herein, the high dielectric layer means a layer showing the property of relative permittivity of not less than 5 (preferably not less than 7, more preferably not less than 15).

As a concrete example thereof, a capacitor made of a high dielectric layer-laminated polyimide film obtained by subjecting a polyimide film to a plasma treatment, forming a nickel-chrome alloy thin film having a thickness of 150 Å and a copper thin film having a thickness of 3000 Å thereon by a sputtering method, forming a copper plating layer having a thickness of 4 μm thereon to give a first electrode layer, forming, on the first electrode layer, a 50 Å titanium oxide thin film as a barrier layer, a $Ba_{0.5}Sr_{0.5}TiO_3$ thin film having a thickness of 2000 nm as a high dielectric layer, and further thereon, a nickel thin film having a thickness of 500 nm and a copper thin film having a thickness of 500 nm by a sputtering method, and further copper plating layer having a thickness of 4 μm to give a second electrode layer can be mentioned.

In the present invention, as a preferable other embodiment, a thin film-laminated polyimide film wherein the nonmetal thin film is a transparent conductive layer can be mentioned. The transparent conductive layer is not limited to the following transparent conductive layer. As used herein, the transparent conductive layer means a layer having the property of a light transmittance of not less than 50% and a relative resistance of $10^4$ Ω·cm or below, which is, for example, constituted from a conductive metal oxide such as tin oxide, indium oxide, zinc oxide, ITO and the like.

As a concrete example thereof, a green organic EL element made of a transparent conductive layer-laminated polyimide film obtained by forming an ITO thin film (transparent conductive layer) and an aluminum layer (first electrode) on a polyimide film by a sputtering method, forming thereon an organic layer containing poly (para-phenylenevinylene) as a luminescence substance by a screen printing method, forming, after drying, an ITO thin film thereon by a sputtering method to give a second electrode, and further forming a fluororesin coating protection film can be mentioned.

In the present invention, as another preferable embodiment, a thin film-laminated polyimide film wherein the nonmetal thin film is a photoelectric conversion layer can be mentioned. The photoelectric conversion layer is not limited to the following photoelectric conversion layer. As used herein, the photoelectric conversion layer means a layer having a function to convert optical stimuli into electric signals, which is constituted by a conventional semiconductor, oxide semiconductor, organic semiconductor, OPC (organic photoconductor) and the like.

As a concrete example thereof, a film like solar battery made of a photoelectric conversion layer-laminated polyimide film obtained by forming a stainless layer having a thickness of 1000 nm on a polyimide film, forming an n-type amorphous silicon layer having a thickness of 25 nm, laminating an i-type amorphous silicon layer having a thickness of 500 nm, further forming a p-type amorphous silicon layer (the above being silicon photoelectric conversion layers) having a thickness of 25 nm by a sputtering method, forming an indium tin oxide (ITO) layer having a thickness of 100 nm by vapor deposition, and forming a palladium layer having a thickness of 100 nm in a comb shape by vacuum vapor deposition can be mentioned.

As mentioned in the foregoing, a thin film-laminated polyimide film using a polyimide film having particular property as a substrate is superior in the planarity and when processed, for example, into a solar battery, capacitor, display and the like, it is free of warpage and distortion, showing superior flat plane retention as well as superior adhesion of a film and a thin film layer.

The film is useful for a product using a film exposed to a high temperature as a substrate, wherein various thin film layers are formed on a substrate by dry plating such as sputtering, ion plating or vapor deposition, and is useful as a reflection preventive film with a metal multi-layer thin film, a characteristic wavelength permeation film with a metal multi-layer thin film and the like.

**[Examples]**

The present invention is explained in more detail in the following by referring to the Examples and Comparative Examples below, which are not to be construed as limitative. The evaluation method of the properties in the following Examples are as shown below, wherein the degree of curl after a heat treatment at 300°C is based on the aforementioned method.

1. thickness of polyimide film

A micrometer (Millitron (registered trade mark) 1245D manufactured by FEINPRUF) was used for the measurement.

2. degree of warpage of film (apparent degree of warpage)

As shown in Fig. 1(C), a 50 mmx50 mm film test piece was stood still on a flat plane to form a concave, an average distance from each top point on the test piece to the flat plane (h1, h2, h3, h4: unit mm) was taken as the amount of warpage (mm), and a value shown by the percentage (%) of the amount of warpage relative to the distance (35.36 mm) from each top point on the test piece to the center was obtained.

Specifically, it was calculated by the following formulas.

amount of warpage (mm)=(h1+h2+h3+h4)/4
degree of warpage (%)=100×(amount of warpage)/35.36

The samples were taken from two points in the width direction and the length direction of the film (basically from points at 1/3 and 2/3 of the beam length, when not possible, taken from the points as near as possible to the central portion), total 4 points, and an average value thereof was used.

The abbreviations of the compounds used in the Examples and the like are shown below.

PMDA: pyromellitic acid dianhydride
TMHQ: P-phenylenebis(trimellitic acid monoester acid anhydride)
ODA: 4,4'-diaminodiphenyl ether
P-PDA: para-phenylenediamine
BPDA: 3,3',4,4'-biphenyltetracarboxylic acid dianhydride
DMF: dimethylformamide
DMAC: dimethylacetamide
AA: acetic anhydride
IQ: isoquinoline

In addition, the abbreviation GF shows a polyimide precursor film (green film) and the abbreviation IF shows a polyimide film.

(Production Examples 1 - 3)

A container equipped with a nitrogen inlet tube, a thermometer and a stirrer bar was substituted with nitrogen, and P-PDA was placed therein. Then, DMAC was added and, after complete dissolution, BPDA was added, and the mixture was polymerized by stirring at 25°C for 5 hr at a molar ratio of P-PDA and BPDA as monomers of 1/1 in DMAC while adjusting the monomer charge concentration to 15 mass %. As a result, a brown viscous polyamic acid solution was obtained. AA (15 parts by mass) and IQ (3 parts by mass) were added per 100 parts by mass of the obtained polyamic acid solution, and the mixture was applied to the lubricant-free surface of a polyester film (COSMOSHINE (registered trade mark) A4100, manufactured by Toyo Boseki Kabushiki Kaisha) having a thickness of 188 micron and a width of 800 mm, in a coating width of 740 mm (squeegee/belt gap 430 μm). The film was dried during passage through a continuous drying furnace having 4 drying zones. In each zone, 3 rows of slit-like air outlets were set for each of the above and under the film, hot air temperature between respective air outlets was controllably set to ±1.5°C, and the air amount difference was controllably set to ±3%. In the width direction, the temperature was controlled to ±1°C for the width corresponding to 1.2-fold of the film effective width.

The temperature at 30 mm above and under the film was set as follows.

drying conditions A
leveling zone temperature 25˚C, no air amount
first zone upper side temperature 105˚C, lower side temperature 105˚C
air amount, both upper and lower 20 - 25 m$^3$/min
second zone upper side temperature 100˚C, lower side temperature 100˚C
air amount, both upper and lower 30 - 35 m$^3$/min
third zone upper side temperature 95˚C, lower side temperature 100˚C
air amount, both upper and lower 20 - 25 m$^3$/min
fourth zone upper side temperature 90˚C, lower side temperature 100˚C
upper side air amount 15m$^3$/min, lower side air amount 20 m$^3$/min

The length of each zone was the same and the total drying time was 18 min.

The air amount was the total of the air amount from the air outlet of each zone. In the Production Example 1, Production Example 2 and Production Example 3, the amount was changed within the above-mentioned range.

Under such drying conditions, the coated film surface up to the third zone did not reach the dry state by touch, which confirmed the almost constant rate of drying conditions.

The coated film surface reached the dry to touch state shortly after entering the fourth zone and the drying proceeded in a rate decreasing drying manner thereafter. At this point, the temperature and the air amount on the lower side were set higher than those of the upper side to promote diffusion of the solvent in the coated film.

By a thermocouple supported at 10 mm above the film and in a part directly beneath the air outlet at the center of each zone, it was confirmed by 10 cm interval monitoring that the temperature was ±1.5˚C.

By releasing the polyamic acid film that became self-supporting after the drying from the polyester film, each green film, i.e., Production Example 1, Production Example 2 and Production Example 3 were obtained. The temperature of the release atmosphere was 27˚C. The release conditions in the following Production Examples were the same.

Each of the obtained green films was subjected to 2-step heating under the conditions of first step: 180˚C, 5 min, temperature rise rate 4˚C/sec, second step: 400˚C, 5 min, by passing the films through a nitrogen-substituted continuous heat treating furnace while holding the both ends thereof on a pin tenter to perform an imidation reaction. Thereafter, by cooling to room temperature over 5 min, each brown polyimide film, i.e., IF Production Example 1, IF Production Example 2 and IF Production Example 3 were obtained.

During the heat treatment of the green films, brushes made of aromatic polyamide monofilament strands were set in contact with the both ends of the film, so that the both ends of the film could be uniformly pierced by the pins of the pin tenter.

The thickness and degree of curl of each polyimide film obtained were 25 μm, 1.8% for IF Production Example 1, 25.1 μm, 3.8% for IF Production Example 2, and 25 μm, 6.5% for IF Production Example.

(Production Examples 4 - 6)

A container equipped with a nitrogen inlet tube, a thermometer and a stirrer bar was substituted with nitrogen, and P-PDA was placed therein. Then, DMAC was added and, after complete dissolution, BPDA was added, and the mixture was polymerized by stirring at 25˚C for 5 hr at a molar ratio of P-PDA and BPDA as monomers of 1/1 in DMAC while adjusting the monomer charge concentration to 15 mass %. As a result, a brown viscous polyamic acid solution was obtained. The obtained polyamic acid solution was applied to a stainless belt (gap between squeegee/belt 450 μm), and dried in the same manner as in Production Examples 1 - 3. By releasing the polyamic acid film that became self-supporting after the drying from the stainless belt, each green film, i.e., Production Example 4, Production Example 5 and Production Example 6 were obtained.

The obtained green films were subjected to 2-step heating under the conditions of first step: 180˚C, 3 min, temperature rise rate 4˚C/sec, second step: 460˚C, 2 min, by passing the films through a nitrogen-substituted continuous heat treating furnace to perform an imidation reaction. Thereafter, by cooling to room temperature over 5 min, each brown polyimide film having a thickness of 25 μm, i.e., IF Production Example 4, IF Production Example 5 and IF Production Example 6 were obtained.

During the heat treatment of the green films, brushes made of aromatic polyamide monofilament strands were set in contact with the both ends of the film, so that the both ends of the film could be uniformly pierced by the pins of the pin tenter.

The thickness and degree of curl of each polyimide film obtained were 25 μm, 4.5% for IF Production Example 4, 25.1 μm, 5.8% for IF Production Example 5 and 25 μm, 8.5% for IF Production Example 6.

(Production Examples 7 - 9)

AA (15 parts by mass) and IQ (3 parts by mass) were added per 100 parts by mass of the polyamic acid solution obtained in Production Example 1, and the mixture was applied to a stainless belt (squeegee/belt gap 430 μm) and dried in a dryer similar to that in Production Examples 1 - 3. The drying conditions (temperature at 30 mm above and under the film) were as follows.

leveling zone temperature 25˚C, no air amount
first zone temperature 110˚C for above and under

air amount, both upper and lower 20 - 25 m³/min
second zone temperature 120˚C for above and under

air amount, both upper and lower 20 - 25 m³/min
third zone temperature 120˚C for above and under
air amount, both upper and lower 20 - 25 m³/min
fourth zone temperature 120˚C for above and under
air amount, both upper and lower 20 - 25 m³/min

The length of each zone was the same and the total drying time was 9 min.

The air amount was the total of the air amount from the air outlet of each zone. In the Production Example 7, Production Example 8 and Production Example 9, the amount was changed within the above-mentioned range.

Under such drying conditions, the coated film surface reached the dry state by touch at the center of the second zone, and it is presumed that the drying proceeded in a rate decreasing drying manner thereafter.

By releasing the polyamic acid film that became self-supporting after the drying from the stainless belt, each green film, i.e., Production Example 7, Production Example 8 and Production Example 9 were obtained.

Each of the obtained green films was subjected to 2-step heating under the conditions of first step: 180˚C, 5 min, temperature rise rate 4˚C/sec, second step: 400˚C, 5 min, by passing the films through a nitrogen-substituted continuous heat treating furnace while holding the both ends thereof on a pin tenter to perform an imidation reaction. Thereafter, by cooling to room temperature over 5 min, each brown polyimide film, i.e., IF Production Example 7, IF Production Example 8 and IF Production Example 9 were obtained.

The thickness and degree of curl of each polyimide film obtained were 25 μm, 10.5% for IF Production Example 7, 25.1 μm, 13.1% for IF Production Example 8, and 25 μm, 20.5% for IF Production Example 7.

(Production Examples 10 - 12)

A container equipped with a nitrogen inlet tube, a thermometer and a stirrer bar was substituted with nitrogen, and ODA was placed therein. Then, DMAC was added and, after complete dissolution, PMDA was added, and the mixture was polymerized by stirring at 25˚C for 5 hr at a molar ratio of ODA and PMDA as monomers of 1/1 in DMAC while adjusting the monomer charge concentration to 15 mass %. As a result, a brown viscous polyamic acid solution was obtained.

AA (15 parts by mass) and IQ (3 parts by mass) were added per 100 parts by mass of the obtained polyamic acid solution, and the mixture was applied to the lubricant-free surface of a polyester film (COSMOSHINE (registered trade mark) A4100, manufactured by Toyo Boseki Kabushiki Kaisha) having a thickness of 188 μm and a width of 800 mm, in a coating width of 740 mm (squeegee/belt gap 430 μm). The film was dried during passage through a continuous drying furnace having 4 drying zones. In each zone, 3 rows of slit-like air outlets were set for each of the above and under the film, hot air temperature between respective air outlets was controllably set to ±1.5˚C, and the air amount difference was controllably set to ±3%. In the width direction, the temperature was controlled to ±1˚C for the width corresponding to 1.2-fold of the film effective width.

The drying furnace was set as shown below. In the drying conditions, the temperature was at 30 mm above and under the film.

leveling zone temperature 25˚C, no air amount
first zone upper side temperature 105˚C, lower side temperature 105˚C
air amount, both upper and lower 20 - 25 m³/min
second zone upper side temperature 100˚C, lower side temperature 100˚C
air amount, both upper and lower 30 - 35 m³/min
third zone upper side temperature 95˚C, lower side temperature 100˚C
air amount, both upper and lower 20 - 25 m³/min
fourth zone upper side temperature 90˚C, lower side temperature 100˚C
upper side air amount 15 - 18 m³/min, lower side air amount 20 - 25 m³/min

The length of each zone was the same and the total drying time was 18 min.

The air amount was the total of the air amount from the air outlet of each zone. In the Production Example 10, Production Example 11 and Production Example 12, the amount was changed within the above-mentioned range.

Under such drying conditions, the coated film surface up to the third zone did not reach the dry state by touch, which confirmed the almost constant rate of drying conditions.

The coated film surface reached the dry to touch state shortly after entering the fourth zone and the drying proceeded in a rate decreasing drying manner thereafter. At this point, the temperature and the air amount on the lower side were set higher than those of the upper side to promote diffusion of the solvent in the coated film.

By a thermocouple supported at 10 mm above the film and in a part directly beneath the air outlet at the center of each zone, it was confirmed by 10 cm interval monitoring that the temperature was ±1.5˚C.

By releasing the polyamic acid film that became self-supporting after the drying from the polyester film, each green film, i.e., Production Example 10, Production Example 11 and Production Example 12 were obtained.

Each of the obtained green films were subjected to 2-step heating under the conditions of first step: 180˚C, 5 min, temperature rise rate 4˚C/sec, second step: 400˚C, 5 min, by passing the films through a nitrogen-substituted continuous heat treating furnace while holding the both ends thereof on a pin tenter to perform an imidation reaction. Thereafter, by cooling to room temperature over 5 min, each brown polyimide film, i.e., IF Production Example 10, IF Production Example 11 and IF Production Example 12 were obtained.

During the heat treatment of the green films, brushes made of aromatic polyamide monofilament strands were set in contact with the both ends of the film, so that the both ends of the film could be uniformly pierced by the pins of the pin tenter.

The thickness and degree of curl of each polyimide film obtained were 25 $\mu$m, 2.8% for IF Production Example 10, 25.1 $\mu$m, 4.1% for IF Production Example 11 and 25 $\mu$m and 7.5% for IF Production Example 12.

(Production Examples 13 - 15)

Using 4 kinds of monomers of PMDA and BPDA as an aromatic tetracarboxylic acid dianhydride component and ODA and P-PDA as a diamine component, the mixture was polymerized in DMF at a molar ratio of PMDA/BPDA/ODA/P-PDA of 1/0.5/1/0.5, while adjusting the monomer charge concentration to 16 mass %, whereby a solution of polyamic acid in DMF was obtained. The obtained polyamic acid solution was applied to a stainless belt (gap between squeegee/belt 400 $\mu$m), and dried in the same manner as in Production Examples 10 - 12.

By releasing the polyamic acid film that became self-supporting after the drying from the stainless belt, each green film having a thickness of 49.5 $\mu$m, i.e., Production Example 13, Production Example 14 and Production Example 15 were obtained.

The obtained green films were subjected to 2-step heating under the conditions of first step: 180˚C, 3 min, temperature rise rate 4˚C/sec, second step: 460˚C, 2 min, by passing the films through a nitrogen-substituted continuous heat treating furnace to perform an imidation reaction. Thereafter, by cooling to room temperature over 5 min, each brown polyimide film having a thickness of 25 $\mu$m, i.e., IF Production Example 13, IF Production Example 14 and IF Production Example 15 were obtained.

During the heat treatment of the green films, brushes made of aromatic polyamide monofilament strands were set in contact with the both ends of the film, so that the both ends of the film could be uniformly pierced by the pins of the pin tenter.

The thickness and degree of curl of each polyimide film obtained were 25 $\mu$m, 4.8% for IF Production Example 13, 25.1 $\mu$m, 7.8% for IF Production Example 14 and 25 $\mu$m, 9.5% for IF Production Example 15.

(Production Examples 16 - 18)

AA (15 parts by mass) and IQ (3 parts by mass) were added per 100 parts by mass of the polyamic acid solution obtained in Production Example 10, and the mixture was applied to a stainless belt (squeegee/belt gap 430 $\mu$m) and dried in a dryer similar to that in Production Examples 10 - 12. The drying conditions (temperature at 30 mm above and under the film) were as follows.

> leveling zone temperature 25˚C, no air amount
> first zone temperature 110˚C for above and under
> air amount, both upper and lower 20 - 25 m³/min
> second zone temperature 120˚C for above and under
> air amount, both upper and lower 20 - 25 m³/min
> third zone temperature 120˚C for above and under
> air amount, both upper and lower 20 - 25 m³/min
> fourth zone temperature 120˚C for above and under
> air amount, both upper and lower 20 - 25 m³/min

The length of each zone was the same and the total drying time was 9 min.

The air amount was the total of the air amount from the air outlet of each zone. In the Production Example 16, Production Example 17 and Production Example 18, the amount was changed within the above-mentioned range.

Under such drying conditions, the coated film surface reached the dry state by touch at the center of the second zone, and it is presumed that the drying proceeded in a rate decreasing drying manner thereafter.

By releasing the polyamic acid film that became self-supporting after the drying from the stainless belt, 3 kinds of green film, i.e., Production Example 16, Production Example 17 and Production Example 18 were obtained.

Each of the obtained green films was subjected to 2-step heating under the conditions of first step: 180˚C, 5 min, temperature rise rate 4˚C/sec, second step: 400˚C, 5 min, by passing the films through a nitrogen-substituted continuous heat treating furnace while holding the both ends thereof on a pin tenter to perform an imidation reaction. Thereafter, by cooling to room temperature over 5 min, each brown polyimide film, i.e., IF Production Example 16, IF Production Example 17 and IF Production Example 18 were obtained.

The thickness and degree of curl of each polyimide film obtained were 25 $\mu$m, 10.8% for IF Production Example 16, 25.1$\mu$m, 14.1% for IF Production Example 17, and 25 $\mu$m, 22.5% for IF Production Example 18.

<Production method of metallized polyimide film>

(Examples 1 - 6, Comparative Examples 1 - 3)

The films obtained in Production Examples 1 - 9 were cut out in a 25 cmx25 cm square and 5 pieces each were used.

Each film was sandwiched and fixed between stainless frames having an opening of 24 cm diameter. Then, the film surface was subjected to a plasma treatment. The plasma treatment conditions were in a xenon gas, frequency 13.56 MHz, output 100 W and gas pressure 0.8 Pa, and the temperature during treatment was 25°C, and the treatment time was 5 min. Then, a nickel-chrome metal underlayer having a thickness of 50 Å was formed using the conditions of frequency 13.56 MHz, output 400 W and gas pressure 0.8 Pa, and a nickel-chrome (3%) alloy target under a xenon atmosphere by an RF sputtering method at a rate of 10 Å/sec. The temperature of the substrate was raised to 250°C, copper was vapor deposited at a rate of 100 Å/sec to form a 0.5 $\mu$m-thick copper thin film layer, whereby a thin film layer formation metallized polyimide film was obtained.

The obtained thin film layer formation metallized polyimide film was fixed again in a plastic frame, and a 5 $\mu$m-thick film copper layer was formed using a copper sulfate plating bath and successively subjected to a heat treatment at 300°C for 10 min to give the object metallized polyimide film.

The metallized polyimide films produced using the films obtained in Production Examples 1 - 6 were used as Examples 1 - 6, respectively. In addition, the metallized polyimide films produced using the films obtained in Production Examples 7 - 9 were used as Comparative Examples 1 - 3, respectively.

Each of the thin film layer formation metallized polyimide films obtained from respective films was evaluated using the average value of the degree of warpage of respective five pieces. Of the respective films, a film having an average degree of warpage exceeding 10% was rated x, a film having a degree of warpage exceeding 7% and up to 10% was rated $\triangle$, a film showing 5 - 7% was rated $\bigcirc$, and a film showing less than 5% was rated $\odot$.

As a result, Example 1, Example 2 and Example 4 are all $\odot$, Example 3 and Example 5 are $\bigcirc$, Example 6 is $\triangle$, and Comparative Example 1, Comparative Example 2 and Comparative Example 3 are all x.

Using each metallized polyimide film obtained in the same manner, photoresist: FR-200, manufactured by SHIPLEY COMPANY L.L.C., was applied and dried, contact exposed with a glass photomask and further developed with an 1.2 mass % KOH aqueous solution. Then, the film was etched using an etching line of cupric chloride containing HCl and hydrogen peroxide, at 40°C, spray pressure of 2 kgf/cm$^2$ to form a test pattern, after which subjected to electroless tin plating in a thickness of 0.5 $\mu$m. Thereafter, an anneal treatment at 125°C was performed for 1 hr, a model substrate having a wiring pattern and an electrode pad for flip chip mounting was obtained from each metallized polyimide film.

Further, a model chip was flip chip mounted on the obtained model substrate.

The wiring patterns of Example 1, Example 2, Example 3, Example 4, Example 5 and Example 6 were free of detachment of a conductor metal pattern or warpage, and the wiring patterns of Comparative Example 1, Comparative Example 2 and Comparative Example 3 showed detachment in the conductor metal pattern and warpage.

In addition, the model chips which were mounted on the model substrates obtained in Example 1, Example 2, Example 3, Example 4, Example 5 and Example 6 showed no connection failure at all 512 contact points, but connection failure occurred in 5 out of 512 points showed in Comparative Example 1, 11 out of 512 points in Comparative Example 2 and 25 out of 512 points in Comparative Example 3.

(Examples 7 - 12, Comparative Examples 4 - 6)

Using six films respectively obtained in Production Examples 1 - 9, a plasma treatment similar to that in Examples 1 - 6 and Comparative Examples 1 - 3 was applied to the front and the back of the films. Then, films after the plasma treatment were set in vacuum apparatuses having the same sputtering area, and a 150 Å nickel-chrome metal alloy underlayer was formed using the conditions of frequency 13.56 MHz, output 400 W and gas pressure 0.8 Pa, and a nickel-chrome (chrome 7%) target under a xenon atmosphere by an RF sputtering method. Then, a copper thin film layer having a thickness of 3000 angstrom was formed by sputtering using a copper target. Furthermore, the film was set in reverse, and the backside was applied to a similar treatment to give each thin film layer formation metallized polyimide film wherein the front and the back were metallized.

The metallized polyimide films produced using the films obtained in Production Examples 1 - 6 were used as Examples 7 - 12, respectively. In addition, the metallized polyimide films produced using the films obtained in Production Examples 7 - 9 were used as Comparative Examples 4 - 6, respectively.

Each of the obtained both side thin film layer formation metallized polyimide films was cut into a size of 200 mmx200 mm, a through-hole was made at a given position by YAG laser, a conventional silver chloride/palladium chloride catalyst was added and activated, an electroless copper plating film was formed on the through-hole part and the copper thin film layer surface by wet electroless copper plating, and panel plating was performed by copper sulfate plating in the state of being fixed in a plastic frame to reach a copper thick film layer thickness of 4.5 $\mu$m to give respective metallized polyimide films.

Each of the thin film layer formation metallized polyimide films obtained from respective films was evaluated using the average value of the degree of warpage of respective five pieces. Of the respective films, a film having an average degree of warpage exceeding 10% was rated x, a film having a degree of warpage exceeding 7% and up to 10% was rated $\triangle$, a film showing 5 - 7% was rated $\bigcirc$, and a film showing less than 5% was rated $\odot$.

As a result, Example 7, Example 8 and Example 10 are all $\odot$, Example 9 and Example 11 are both $\bigcirc$, Example 12 is $\triangle$, and Comparative Example 4, Comparative Example 5 and Comparative Example 6 are all x.

The metallized polyimide film obtained after panel plating was subjected to double-sided fine line processing at line width/line interval=7/7 $\mu$m. Specifically, photoresist: FR-200, manufactured by SHIPLEY COMPANY L.L.C., was applied and dried, contact exposed with a glass photomask and further developed with an 1.2 % KOH aqueous solution. Then, the metal layer was etched using an etching line of cupric chloride containing HCl and hydrogen peroxide, at 40˚C, spray pressure of 2 kgf/cm$^2$, and the resist was removed after the etching to give each double-sided circuit pattern.

In the respective double-sided circuit patterns using the substrate films of Production Example 1 - Production Example 6, processing of line width/line interval was performed without less dispersion at a size slightly narrower than the negative, and detachment of pattern and warpage were absent. However, in respective double-sided circuit patterns using the substrate films of Production Example 7 - Production Example 9, the variation in the line width was large, detachment of pattern was observed and the circuit patterns contained warpage.

(Examples 13 - 18, Comparative Examples 7 - 9)

The polyimide films obtained in Production Examples 1 - 9 (6 films each) were cut out in a 25 cmx25 cm square and sandwiched and fixed between stainless frames having an opening of 24 cm diameter. Then, the film surface was subjected to a plasma treatment. The plasma treatment conditions were in a xenon gas, frequency 13.56 MHz, output 100 W and gas pressure 0.8 Pa, and the temperature during treatment was 25˚C, and the treatment time was 5 min. Then, a coated film of a nickel-chrome alloy metal underlayer having a thickness of 50 Å was formed using the conditions of frequency 13.56 MHz, output 400 W and gas pressure 0.8 Pa, and a nickel-chrome (3% by mass) alloy target under a xenon atmosphere by an RF sputtering method at a rate of 10 Å/sec. The temperature of the substrate was then raised to 250˚C, copper was vapor deposited at a rate of 100 Å/sec to form a 0.5 $\mu$m-thick copper thin film layer, whereby each thin film layer formation metallized polyimide film was obtained.

The metallized polyimide films produced using the films obtained in Production Examples 1 - 6 were used as Examples 13 - 18, respectively. In addition, the metallized polyimide films produced using the films obtained in Production Examples 7 - 9 were used as Comparative Examples 7 - 9, respectively.

Each of the thin film layer formation metallized polyimide films obtained from respective films was evaluated using the average value of the degree of warpage of respective five pieces. Of the respective films, a film having an average degree of warpage exceeding 10% was rated x, a film having a degree of warpage exceeding 7% and up to 10% was rated $\Delta$, a film showing 5 - 7% was rated ○, and a film showing less than 5% was rated ⊙.

As a result, Example 13, Example 14 and Example 16 are all ⊙, Example 15 and Example 17 are both ○, Example 18 is $\Delta$, and Comparative Example 7, Comparative Example 8 and Comparative Example 9 are all ×.

The obtained each thin film layer formation metallized polyimide film was fixed again in a plastic frame, and a 10 $\mu$m-thick film copper layer was formed using a copper sulfate plating bath and successively subjected to a heat treatment at 300˚C for 10 min to give each metallized polyimide film.

Using each metallized polyimide film from the obtained same polyimide film, a multi-layer printed circuit board was prepared by a batch lamination method.

An adhesive was applied to the opposite surface, on which a copper plating layer had been formed, to a dry film thickness of 12 $\mu$m, and dried. For forming a via hole, YAG laser was used and the via diameter was 150 $\mu$m. A copper sulfate bath was used for via fill plating, and tin-copper-silver alloy plating was used for solder plating. In addition, for protection of a copper plating layer surface during via fill and solder bump formation, UV-curable etching resist ink was used. For pattern formation, photoresist: FR-200, manufactured by SHIPLEY COMPANY L.L.C. was used and, after application and drying of the resist, contact exposed with a glass photomask and further developed with an 1.2 mass % KOH aqueous solution. Then, the film was etched using an etching line of cupric chloride containing HC1 and hydrogen peroxide, at 40˚C, spray pressure of 2 kgf/cm$^2$. Six layers of substrates after pattern formation were superimposed on one another, a 18 $\mu$m-thick low profile electrolytic copper foil was used for the outermost layer, and press-adhered with a vacuum press. Thereafter, pattern processing of the outermost layer was performed to give a multi-layer circuit board having 7 conductor layers (metal layers) including the outermost layer.

The multi-layer circuit boards using the substrate films of Production Example 1 - Production Example 6 all showed no detachment of pattern, but the multi-layer circuit boards using the substrate films of Production Example 7 - Production Example 9 showed detachment of pattern.

(Examples 19 - 24, Comparative Examples 10 - 12)

The films obtained in Production Examples 10 - 18 were each cut out in a 25 cm×25 cm square and 5 pieces each were used.

Each film was sandwiched and fixed between stainless frames having an opening of 24 cm diameter. Then, the film surface was subjected to a plasma treatment. The plasma treatment conditions were in a xenon gas, frequency 13.56 MHz, output 100 W and gas pressure 0.8 Pa, and the temperature during treatment was 25˚C, and the treatment time was 5 min. Then, a nickel-chrome alloy underlayer having a thickness of 50 Å was formed using the conditions of frequency 13.56 MHz, output 400 W and gas pressure 0.8 Pa, and a nickel-chrome (3%) alloy target under a xenon atmosphere by an RF sputtering method at a rate of 10 Å/sec. The temperature of the substrate was then raised to 250˚C, copper was vapor deposited at a rate of 100 Å/sec to form a 0.5 μm-thick copper thin film layer, whereby each metal thin film layer formation metallized polyimide film was obtained.

The obtained each metal thin film layer formation film was fixed again in a plastic frame, and a 5 μm-thick copper plating layer (thick film copper layer) was formed using a copper sulfate plating bath and successively subjected to a heat treatment at 300˚C for 10 min to give the object each thick film metallized polyimide film.

The metallized polyimide films produced using the films obtained in Production Examples 10 - 15 were used as Examples 19 - 24, respectively. In addition, the metallized polyimide films produced using the films obtained in Production Examples 16 - 18 were used as Comparative Examples 10 - 12, respectively.

Each of the metal thin film layer formation metallized polyimide films obtained from respective films was evaluated using the average value of the degree of warpage of respective five pieces. Of the respective films, a film having an average degree of warpage exceeding 10% was rated ×, a film having a degree of warpage exceeding 7% and up to 10% was rated Δ, a film showing 5 - 7% was rated ○, and a film showing less than 5% was rated ⊙.

As a result, Example 19, Example 20 and Example 22 are all ⊙, Example 23 is O, Example 21 and Example 24 are Δ, and Comparative Example 10, Comparative Example 11 and Comparative Example 12 are all x.

Using each of the obtained thick metallized polyimide films, moreover, photoresist: FR-200, manufactured by SHIPLEY COMPANY L.L.C., was applied and dried, contact exposed with a glass photomask and further developed with an 1.2 mass % KOH aqueous solution. Then, a part of all the layers (layer of conductor metal; also referred to as a conductor metal) formed on the film was etched using an etching line of cupric chloride containing HCl and hydrogen peroxide, at 40˚C, spray pressure of 2 kgf/cm$^2$ to form a test pattern, after which subjected to electroless tin plating in a thickness of 0.5 μm. Thereafter, an anneal treatment at 125˚C was performed for 1 hr, a model substrate having a wiring pattern and an electrode pad for flip chip mounting was obtained from each thick metallized polyimide film.

Further, a model chip was flip chip mounted on the obtained model substrate.

The wiring patterns of Example 19, Example 20, Example 21, Example 22, Example 23 and Example 24 were free of detachment of a conductor metal pattern or warpage, and the wiring patterns of Comparative Example 10, Comparative Example 11 and Comparative Example 12 showed detachment in the conductor metal pattern and warpage.

In addition, the model chips which were mounted on the model substrates obtained in Example 19, Example 20, Example 21, Example 22, Example 23 and Example 24 showed no connection failure at all 512 contact points, but connection failure occurred in 3 out of 512 points showed in Comparative Example 10, 7 out of 512 points in Comparative Example 11 and 24 out of 512 points in Comparative Example 12.

(Examples 25 - 30, Comparative Examples 13 - 15)

Using six films respectively obtained in Production Examples 10 - 18, a plasma treatment similar to that in Examples 19 - 24 and Comparative Examples 10 - 12 was applied to the front and the back of the films. Then, films after the plasma treatment were set in vacuum apparatuses having the same sputtering area, and a 150 Å nickel-chrome alloy underlayer was formed using the conditions of frequency 13.56 MHz, output 400 W and gas pressure 0.8 Pa, and a nickel-chrome (chrome 7%) target under a xenon atmosphere by an RF sputtering method. Then, a copper thin film layer having a thickness of 3000 angstrom was formed by sputtering using a copper target. Furthermore, the film was set in reverse, and the backside was applied to a similar treatment to give a metal thin film layer formation metallized polyimide film wherein the front and the back were metallized.

Each of the obtained both side metal thin film layer formation metallized polyimide films was cut into a size of 200 mm×200 mm, a through-hole was made at a given position by YAG laser, a conventional silver chloride/palladium chloride catalyst was added and activated, an electroless copper plating film was formed on the through-hole part and the metallized surface by wet electroless copper plating, and panel plating was performed by copper sulfate plating in the state of being fixed in a plastic frame to reach a conductor copper layer thickness of 4.5 μm to give respective thick film metallized polyimide films.

The metallized polyimide films produced using the films obtained in Production Examples 10 - 15 were used as Examples 25 - 30. In addition, the metallized polyimide films produced using the films obtained in Production Examples 16 - 18 were used as Comparative Examples 13 - 15.

Each of the metal thin film layer formation metallized polyimide films obtained from respective films was evaluated using the average value of the degree of warpage of respective five pieces. Of the respective films, a film having an average degree of warpage exceeding 10% was rated ×, a film having a degree of warpage exceeding 7% and up to 10% was rated Δ, a film showing 5 - 7% was rated O, and a film showing less than 5% was rated ⊙.

As a result, Example 25, Example 26 and Example 28 are all ⊙, Example 29 is ○, Example 27 and Example 30 are Δ, and Comparative Example 13, Comparative Example 14 and Comparative Example 15 are all ×.

Each thick film metallized polyimide film obtained after panel plating was subjected to double-sided fine line processing at line width/line interval=7/7 μm. Specifically, photoresist: FR-200, manufactured by SHIPLEY COMPANY L.L.C., was applied and dried, contact exposed with a glass photomask and further developed with an 1.2 % KOH aqueous solution. Then, the film was etched using an etching line of cupric chloride containing HCl and hydrogen peroxide, at 40˚C, spray pressure of 2 kgf/cm$^2$, and the resist was removed after the etching to give each double-sided circuit pattern.

In the respective double-sided circuit patterns of Example 25 - Example 30, processing of line width/line interval was performed without less dispersion at a size slightly narrower than the negative, and detachment of pattern and warpage were absent. However, in respective double-sided circuit patterns of Comparative Example 13 - Comparative Example 15, the variation in the line width was large, detachment of pattern was observed and also warpage.

(Examples 31 - 36, Comparative Examples 16 - 18)

The polyimide films obtained in Production Examples 10 - 18 (6 films each) were cut out in a 25 cmx25 cm square and sandwiched and fixed between stainless frames having an opening of 24 cm diameter. Then, the film surface was subjected to a plasma treatment. The plasma treatment conditions were in a xenon gas, frequency 13.56 MHz, output 100 W and gas pressure 0.8 Pa, and the temperature during treatment was 25˚C, and the treatment time was 5 min. Then, a nickel-chrome alloy underlayer having a thickness of 50 Å was formed using the conditions of frequency 13.56 MHz, output 400 W and gas pressure 0.8 Pa, and a nickel-chrome (3% by mass) alloy target under a xenon atmosphere by an RF sputtering method at a rate of 10 Å/sec. The temperature of the substrate was then raised to 250˚C, copper was vapor deposited at a rate of 100 Å/sec to form a 0.5 μm-thick copper thin film layer, whereby each thin film layer formation metallized polyimide film was obtained.

The metallized polyimide films produced using the films obtained in Production Examples 10 - 15 were used as Examples 31 - 36, respectively. In addition, the metallized polyimide films produced using the films obtained in Production Examples 16 - 18 were used as Comparative Examples 16 - 18, respectively.

Each of the thin film layer formation metallized polyimide films obtained from respective films was evaluated using the average value of the degree of warpage of respective five pieces. Of the respective films, a film having an average degree of warpage exceeding 10% was rated ×, a film having a degree of warpage exceeding 7% and up to 10% was rated Δ, a film showing 5 - 7% was rated ○, and a film showing less than 5% was rated ⊙.

As a result, Example 31, Example 32 and Example 34 are all ⊙, Example 35 was ○, Example 33 and Example 36 are Δ, and Comparative Example 16, Comparative Example 17 and Comparative Example 18 are all ×.

The each obtained thin film layer formation metallized polyimide film was fixed again in a plastic frame, and a 10 μm-thick film copper playing layer was formed using a copper sulfate plating bath and successively subjected to a heat treatment at 300˚C for 10 min to give each thick film metallized polyimide film.

Using each thick film metallized polyimide film from the obtained same polyimide film, a multi-layer printed circuit board was prepared by a batch lamination method.

An adhesive was applied to the opposite surface, on which a copper plating layer had been formed, to a dry film thickness of 12 μm, and dried. For forming a via hole, YAG laser was used and the via diameter was 150 μm. A copper sulfate bath was used for via fill plating, and tin-copper-silver alloy plating was used for solder plating. In addition, for protection of a copper plating layer during via fill and solder bump formation, UV-curable etching resist ink was used. For pattern formation, photoresist: FR-200, manufactured by SHIPLEY COMPANY L.L.C. was used and, after application and drying of the resist, contact exposed with a glass photomask and further developed with an 1.2 mass % KOH aqueous solution. Then, the film was etched using an etching line of cupric chloride containing HCl and hydrogen peroxide, at 40˚C, spray pressure of 2 kgf/cm$^2$. Six layers of substrates after pattern formation were superimposed on one another, a 18 μm-thick low profile electrolytic copper foil was used for the outermost layer, and press-adhered with a vacuum press. Thereafter, pattern processing of the outermost layer was performed to give a multi-layer circuit board having 7 conductor layers including the outermost layer.

The multi-layer circuit boards using the polyimide films of Production Example 10 - Production Example 15 all showed no detachment of pattern, but the multi-layer circuit boards using the polyimide films of Production Example 16 - Production Example 18 showed detachment of pattern.

(Examples 37 - 42, Comparative Examples 19 - 21)

The respective films obtained in Production Examples 1 - 9 were set in vacuum apparatuses each having an unwinding apparatus, a winding apparatus and a plasma treatment apparatus, and the film surface was treated with plasma.

The plasma treatment conditions were in xenon gas, frequency 13.56 MHz, output 80 W, gas pressure 0.9 Pa, the temperature during treatment was 24˚C, and the residence time in the plasma atmosphere was about 45 sec. Then, films after the plasma treatment were set in vacuum apparatuses having the same unwinding apparatus, winding apparatus and sputtering area, and a 150 Å nickel-chrome alloy coated film was formed using the conditions of frequency 13.56 MHz, output 400 W and gas pressure 0.8 Pa, and a nickel-chrome (chrome 7%) target under a xenon atmosphere by an RF sputtering method. Then, by sputtering using a copper target, a 3000 Å-thick copper thin film was formed, and a thick copper plating layer having a thickness of 4 μm was formed using a copper sulfate plating bath to give a first electrode layer. Sequentially, at a substrate temperature of 450°C, a 50 Å titanium oxide layer was formed as a barrier layer on the first electrode layer, and a 2000 nm thin film high dielectric layer was further formed as a dielectric layer using a $Ba_{0.5}Sr_{0.5}TiO_3$ target by a high frequency sputtering method. Furthermore, 500 nm nickel and 500 nm copper were formed on the thin film high dielectric layer by sputtering and finally, a thick copper plating layer having a thickness of 4 μm was formed using a copper sulfate plating bath to give a second electrode layer, whereby a high dielectric laminate film was obtained.

The high dielectric laminate polyimide films produced using the films obtained in Production Examples 1 - 6 were used as Examples 37 - 42, respectively. In addition, the high dielectric laminate polyimide films produced using the films obtained in Production Examples 7 - 9 were used as Comparative Examples 19 - 21, respectively.

Each of the high dielectric layer-laminated polyimide film was evaluated using the average value of the degree of warpage of respective five pieces. Of the respective films, a film having an average degree of warpage exceeding 10% was rated ×, a film having a degree of warpage exceeding 7% and up to 10% was rated Δ, a film showing 5 - 7% was rated ○, and a film showing less than 5% was rated ⊙.

As a result, Example 37, Example 38 and Example 40 are all ⊙, Example 39, Example 41 and Example 42 are ○, and Comparative Example 19, Comparative Example 20 and Comparative Example 21 are all ×.

In the evaluation of the capacity density and withstand voltage of each of the obtained high dielectric layer-laminated polyimide films, the high dielectric layer-laminated polyimide films of Example 37, Example 38, Example 39, Example 40, Example 41 and Example 42 each showed stable capacity density free of variation and practically sufficient withstand voltage (not less than 100 kV/m). However, the high dielectric layer-laminated polyimide films of Comparative Example 19, Comparative Example 20 and Comparative Example 21 each showed unevenness in the capacity density and withstand voltage of less than 10 kV/m. Furthermore, they showed variation.

(Examples 43 - 48, Comparative Examples 22 - 24)

Using respective polyimide films obtained in Production Examples 1 - 9, a 100 nm thick indium tin oxide (ITO) thin film layer and a 500 nm thick aluminum layer were formed on the polyimide films using a sputtering apparatus to give a first electrode. The first electrode was masked to afford a given shape of an electrode. In addition, an electrode to be mounted on a drive circuit was also formed, which was drawn on the part corresponding to the outside of the element. Then, a luminescence layer was formed on the first electrode. Here, an organic layer containing undoped poly(para-phenylenevinylene) as a luminescence substance was formed by a screen printing method. The maximum film-drying temperature was 180°C. Finally, an ITO thin film layer was formed as the second electrode on the luminescence layer by sputtering, which was then coated with a fluororesin to form a protection film.

The organic EL elements produced using the films obtained in Production Examples 1 - 6 were used as Examples 43 - 48, respectively. In addition, the organic EL elements produced using the films obtained in Production Examples 7 - 9 were used as Comparative Examples 22 - 24, respectively.

A peak to peak 60 V, 1000 Hz alternating current voltage was applied to each organic EL element. As a result, the elements of Example 43, Example 44, Example 45, Example 46, Example 47 and Example 48 showed brilliant green luminescence, but the elements of Comparative Example 22, Comparative Example 23 and Comparative Example 24 showed unstable luminescence.

Of the respective transparent conductive layer-laminated polyimide films obtained from respective polyimide films, a film having an average degree of warpage exceeding 10% was rated ×, a film having a degree of warpage exceeding 7% and up to 10% was rated Δ, a film showing 5 - 7% was rated ○, and a film showing less than 5% was rated ⊙. As a result, Example 43, Example 44 and Example 46 are all ⊙, Example 45, Example 46 and Example 47 are all ○, and Comparative Example 22, Comparative Example 23 and Comparative Example 24 are all ×.

(Examples 49 - 54, Comparative Examples 25 - 27)

Using respective polyimide films obtained in Production Examples 1 - 9, a 1000 nm-thick stainless layer was formed on the above-mentioned respective polyimide films by a sputtering apparatus using a stainless target. Then, a film having a stainless layer was placed between an opposing electrode and a supporting electrode in a vacuum reactor, and the inside of the reactor was once exhausted to $1 \times 10^{-5}$ Torr and the temperature of the supporting electrode was raised to 350°C. Thereafter, a 30 W, 15 MHz high frequency voltage was applied to the opposing electrode and the supporting electrode, during which argon gas was introduced into the reactor to perform presputtering under a 1 Torr argon atmosphere. Then, $SiH_4$ diluted to 10% with hydrogen gas and $PH_3$ gas similarly diluted to 1% with hydrogen gas were simultaneously introduced thereinto, and a 25 nm n-type amorphous silicon layer was formed on the above-mentioned stainless layer under a 1 Torr atmosphere. Then SiH₄ alone was introduced thereinto to laminate a 500 nm-thick i-type amorphous silicon layer on the aforementioned n-type amorphous silicon layer. By further introducing a mixed gas containing 1% B₂H₆ in SiH₄ gas, a 25 nm-thick p-type amorphous silicon layer was formed on the aforementioned i-type amorphous silicon layer.

The film having the pin type amorphous silicon layer was mounted in a vacuum vapor deposition apparatus, and a 100 nm-thick indium tin oxide layer was vapor deposited by an electron beam method to give a hetero electrode layer. Finally, a 100 nm palladium layer was vacuum vapor deposited thereon in a comb shape.

A film-like solar battery was obtained, which was made of the respective photoelectric conversion layer-laminated polyimide films obtained as mentioned above. When the polyimide film substrates of Production Examples 1 - 6 were used in the production step of the film-like solar batteries, problems of development of warpage due to heat, development of wrinkles and the like did not occur and solar batteries having superior planarity were obtained. When the polyimide film substrates of Production Examples 7 - 9 were used, problems of deformation and warpage due to the heat occurred, and solar batteries having superior planarity were difficult to obtain.

Each of the photoelectric conversion layer-laminated polyimide film obtained from respective polyimide films was evaluated using the average value of the degree of warpage of respective five pieces. Of the respective films, a film having an average degree of warpage exceeding 10% was rated ×, a film having a degree of warpage exceeding 7% and up to 10% was rated Δ, a film showing 5 - 7% was rated ○, and a film showing less than 5% was rated ⊙.

The solar batteries produced using the films obtained in Production Examples 1 - 6 were used as Examples 49 - 54, respectively. In addition, the solar batteries produced using the films obtained in Production Examples 7 - 9 were used as Comparative Examples 25 - 27, respectively.

As a result, Example 49, Example 50 and Example 52 are all ⊙, Example 51, Example 53 and Example 54 are all ○, and Comparative Example 25, Comparative Example 26 and Comparative Example 27 are all x.

(Examples 55 - 60, Comparative Examples 28 - 30)

The respective films obtained in Production Examples 10 - 18 were set in vacuum apparatuses each having an unwinding apparatus, a winding apparatus and a plasma treatment apparatus, and the film surface was treated with plasma.

The plasma treatment conditions were in xenon gas, frequency 13.56 MHz, output 80 W, gas pressure 0.9 Pa, the temperature during treatment was 24°C, and the residence time in the plasma atmosphere was about 45 sec. Then, films after the plasma treatment were set in vacuum apparatuses having the same unwinding apparatus, winding apparatus and sputtering area, and a 150 Å nickel-chrome alloy coated film was formed using the conditions of frequency 13.56 MHz, output 400 W and gas pressure 0.8 Pa, and a nickel-chrome (chrome 7%) target under a xenon atmosphere by an RF sputtering method. Then, by sputtering using a copper target, a 3000 Å-thick copper thin film was formed, and a thick copper plating layer having a thickness of 4 μm was formed using a copper sulfate plating bath to give a first electrode layer. Sequentially, at a substrate temperature of 450°C, a 50 Å titanium oxide layer was formed as a barrier layer on the first electrode layer, and a 2000 nm thin film high dielectric layer was further formed as a dielectric layer using a $Ba_{0.5}Sr_{0.5}TiO_3$ target by a high frequency sputtering method. Furthermore, 500 nm nickel and 500 nm copper were formed on the thin film high dielectric layer by sputtering and finally, a thick copper plating layer having a thickness of 4 μm was formed using a copper sulfate plating bath to give a second electrode layer, whereby a high dielectric laminate film was obtained.

The high dielectric laminate polyimide films produced using the films obtained in Production Examples 10 - 15 were used as Examples 55 - 60, respectively. In addition, the high dielectric laminate polyimide films produced using the films obtained in Production Examples 16 - 18 were used as Comparative Examples 28 - 30, respectively.

Each of the high dielectric layer-laminated polyimide films obtained from respective films was evaluated using the average value of the degree of warpage of respective five pieces. Of the respective films, a film having an average degree of warpage exceeding 10% was rated ×, a film having a degree of warpage exceeding 7% and up to 10% was rated Δ, a film showing 5 - 7% was rated ○, and a film showing less than 5% was rated ⊙.

As a result, Example 55, Example 56 and Example 58 are all ⊙, Example 59 is ○, Example 57 and Example 60 are Δ, and Comparative Example 28, Comparative Example 29 and Comparative Example 30 are all ×.

In the evaluation of the capacity density and withstand voltage of each of the obtained high dielectric layer-laminated polyimide films, the high dielectric layer-laminated polyimide films of Example 55, Example 56, Example 57, Example 58, Example 58 and Example 60 each showed stable capacity density free of variation and practically sufficient withstand voltage (not less than 100 kV/m). However, the high dielectric layer-laminated polyimide films of Comparative Example 28, Comparative Example 29 and Comparative Example 30 each showed unevenness in the capacity density and withstand voltage of less than 10 kV/m. Furthermore, they showed variation.

(Examples 61 - 66, Comparative Examples 31 - 33)

Using respective polyimide films obtained in Production Examples 10 - 18, a 100 nm thick indium tin oxide (ITO) thin film layer and a 500 nm thick aluminum layer were formed on the polyimide films using a sputtering apparatus to give a first electrode. The first electrode was masked to afford a given shape of an electrode. In addition, an electrode to be mounted on a drive circuit was also formed, which was drawn on the part corresponding to the outside of the element. Then, a luminescence layer was formed on the first electrode. Here, an organic layer containing undoped poly(para-phenylenevinylene) as a luminescence substance was formed by a screen printing method. The maximum film-drying temperature was 180°C. Finally, an ITO thin film layer was formed as the second electrode on the luminescence layer by sputtering, which was then coated with a fluororesin to form a protection film.

A peak to peak 60 V, 1000 Hz alternating current voltage was applied to the organic EL element made of a transparent conductive layer-laminated polyimide film made of the obtained respective polyimide films. As a result, the elements of Example 61, Example 62, Example 63, Example 64, Example 65 and Example 66 showed brilliant green luminescence, but the elements of Comparative Example 31, Comparative Example 32 and Comparative Example 33 showed unstable luminescence.

Of the respective transparent conductive layer-laminated polyimide films, a film having an average degree of warpage exceeding 10% was rated x, a film having a degree of warpage exceeding 7% and up to 10% was rated $\Delta$, a film showing 5 - 7% was rated O, and a film showing less than 5% was rated ⊙. As a result, Example 61, Example 62 and Example 64 are all ⊙, Example 65 is O, Example 63 and Example 66 are $\Delta$, and Comparative Example 31, Comparative Example 32 and Comparative Example 33 are all ✕.

(Examples 67 - 72, Comparative Examples 34 - 36)

Using respective polyimide films obtained in Production Examples 10 - 18, a 1000 nm-thick stainless layer was formed on the above-mentioned respective polyimide films by a sputtering apparatus using a stainless target. Then, a film having a stainless layer was placed between an opposing electrode and a supporting electrode in a vacuum reactor, and the inside of the reactor was once exhausted to $10^{-5}$ Torr and the temperature of the supporting electrode was raised to 350°C. Thereafter, a 30 W, 15 MHz high frequency voltage was applied to the opposing electrode and the supporting electrode, during which argon gas was introduced into the reactor to perform presputtering under a 1 Torr argon atmosphere. Then, $SiH_4$ diluted to 10% with hydrogen gas and $PH_3$ gas similarly diluted to 1% with hydrogen gas were simultaneously introduced thereinto, and a 25 nm n-type amorphous silicon layer was formed on the above-mentioned stainless layer under a 1 Torr atmosphere. Then $SiH_4$ alone was introduced thereinto to laminate a 500 nm-thick i-type amorphous silicon layer on the aforementioned n-type amorphous silicon layer. By further introducing a mixed gas containing 1% $B_2H_6$ in $SiH_4$ gas, a 25 nm-thick p-type amorphous silicon layer was formed on the aforementioned i-type amorphous silicon layer.

The film having the pin type amorphous silicon layer was mounted in a vacuum vapor deposition apparatus, and a 100 nm-thick indium tin oxide layer was vapor deposited by an electron beam method to give a hetero electrode layer. Lastly, a 100 nm palladium layer was vacuum vapor deposited thereon in a comb shape.

A film-like solar battery was obtained, which was made of the respective photoelectric conversion layer-laminated polyimide films obtained as mentioned above. When the polyimide film substrates of Production Examples 10 - 15 were used in the production step of the film-like solar batteries, problems of development of warpage due to heat, development of wrinkles and the like did not occur and solar batteries having superior planarity were obtained. When the polyimide film substrates of Production Examples 16 - 18 were used, problems of deformation and warpage due to heat occurred, and solar batteries having superior planarity were difficult to obtain.

Each of the photoelectric conversion layer-laminated polyimide films obtained from respective polyimide films was evaluated using the average value of the degree of warpage of respective five pieces. Of the respective films, a film having an average degree of warpage exceeding 10% was rated ✕, a film having a degree of warpage exceeding 7% and up to 10% was rated $\Delta$, a film showing 5 - 7% was rated ○, and a film showing less than 5% was rated ⊙.

The metallized polyimide films produced using the films obtained in Production Examples 10 - 15 were used as Examples 67 - 72, respectively. In addition, the metallized polyimide films produced using the films obtained in Production Examples 16 - 18 were used as Comparative Examples 34 - 36, respectively.

As a result, Example 67, Example 68 and Example 70 are all ⊙, Example 71 is ○, Example 69 and Example 72 are $\Delta$, and Comparative Example 34, Comparative Example 35 and Comparative Example 36 are all ✕.

From the aspect of the property as a solar battery, the battery of each Example showed a conversion efficiency of 3 - 5%, and had a photoelectric conversion ability of a practical level, but the battery of each Comparative Example showed a photoelectric conversion efficiency of less than 1%, showing low practicality.

**Industrial Applicability**

The thin film-laminated polyimide film of the present invention can be used as a substrate film for electronic parts. For example, in a printed circuit board, a metal thin film layer and a metal thick film layer are formed on one surface or both surfaces of a polyimide film, from which, for example, a wiring pattern having a wire width of 5 - 30 $\mu$m, wire interval of 5 - 30 $\mu$m and a thickness of about 3 - 40 $\mu$m is formed. Moreover, for example, in a solar battery, a capacitor and the like, for example, a silicon photoelectric conversion layer or a high dielectric layer is formed on one surface or both surfaces of a polyimide film. During formation of the metal thin film layer, silicon photoelectric conversion layer or high dielectric layer-forming lamination, the substrate film is subjected to vapor deposition, sputtering, other heat treatment and chemical medication treatment. In most cases, one surface is first subjected to such treatment during the various treatments. By setting the property difference between the front and the back surfaces of a polyimide film, particularly the degree of curl after a heat treatment at 300˚C, to given level or below, the polyimide film hardly shows warpage or distortion particularly during a high temperature treatment. As a result, the quality and yield of the obtained printed circuit board and the like are improved. In addition, the film can maintain planarity even after a subsequent high temperature treatment applied to such printed circuit board and the like (e.g., anneal treatment, solder treatment and the like). Thus, the product yield thereof can be improved.

As mentioned above, the polyimide film as a heat resistance film is often exposed to heat, where a low degree of curl of the film due to heat after a heat treatment at 300˚C is an extremely important quality when the film is applied to a substrate and the like of an industrial product.

A thin film-laminated polyimide film using a particular polyimide film is industrially extremely significant because use thereof as a substrate of electronic parts and the like to be exposed to a high temperature prevents easy development of warpage and distortion of the substrate during production, and can improve quality and yield of electronic parts.

This application is based on patent application Nos. 2005-119994, 2005-119995, 2005-121179 and 2005-121180 filed in Japan, the contents of which are incorporated in full herein by this reference.

**Claims**

1. A thin film-laminated polyimide film comprising a polyimide film having a degree of curl after a heat treatment at 300˚C of not more than 10% as a substrate film, wherein a thin film layer is formed on at least one surface of the substrate film.

2. The thin film-laminated polyimide film of claim 1, wherein the degree of curl after a heat treatment at 300˚C is not more than 8%.

3. The thin film-laminated polyimide film of claim 1 or 2, wherein the polyimide film is made of a polyimide obtained by reacting aromatic tetracarboxylic acid with aromatic diamine.

4. The thin film-laminated polyimide film of claim 3, wherein the polyimide comprises at least a pyromellitic acid residue as an aromatic tetracarboxylic acid residue, and at least a diaminodiphenyl ether residue as an aromatic diamine residue.

5. The thin film-laminated polyimide film of claim 4, which further comprises a biphenyltetracarboxylic acid residue as an aromatic tetracarboxylic acid residue, and further comprises a p-phenylenediamine residue as an aromatic diamine residue.

6. The thin film-laminated polyimide film of claim 3, wherein the polyimide comprises at least a biphenyltetracarboxylic acid residue as an aromatic tetracarboxylic acid residue, and comprises at least a phenylenediamine residue as an aromatic diamine residue.

7. The thin film-laminated polyimide film of any one of claims 1 to 6, wherein the thin film layer is a metal thin film layer.

8. The thin film-laminated polyimide film of claim 7, wherein the metal thin film layer is formed by dry plating method.

9. The thin film-laminated polyimide film of claim 7 or 8, wherein the metal thin film layer is formed via an underlayer.

10. The thin film-laminated polyimide film of any one of claims 7 to 9, wherein a metal thick film layer is laminated on the metal thin film layer.

11. The thin film-laminated polyimide film of claim 10, wherein the metal thick film layer is formed by wet plating method.

12. The thin film-laminated polyimide film of any one of claims 1 to 6, wherein the thin film layer is made of a nonmetal layer.

13. The thin film-laminated polyimide film of claim 12, wherein the nonmetal layer is formed by dry plating method.

14. The thin film-laminated polyimide film of claim 12 or 13, wherein the nonmetal layer is a high dielectric layer.

15. The thin film-laminated polyimide film of claim 12 or 13, wherein the nonmetal layer is a transparent conductive layer.

**16.** The thin film-laminated polyimide film of claim 12 or 13, wherein the nonmetal layer is a photoelectric conversion layer.

**17.** A flexible printed circuit board comprising the thin film-laminated polyimide film of any one of claims 7 to 11, wherein the metal layer is partly removed.

**18.** A flexible printed circuit board comprising the flexible printed circuit board of claim 17 and a semiconductor chip mounted thereon.

**19.** A semiconductor device comprising the flexible printed circuit board of claim 17 and a semiconductor chip mounted thereon.

# FIG. 1

(a)

50mm

50mm

(b)

(c)

$h_1$     $h_4$

**INTERNATIONAL SEARCH REPORT**

| | International application No. |
|---|---|
| | PCT/JP2005/012623 |

A. CLASSIFICATION OF SUBJECT MATTER
**B32B27/34**(2006.01)

According to International Patent Classification (IPC) or to both national classification and IPC

B. FIELDS SEARCHED

Minimum documentation searched (classification system followed by classification symbols)
**B32B1/00-35/00**(2006.01)

Documentation searched other than minimum documentation to the extent that such documents are included in the fields searched
Jitsuyo Shinan Koho          1922-1996   Jitsuyo Shinan Toroku Koho   1996-2005
Kokai Jitsuyo Shinan Koho    1971-2005   Toroku Jitsuyo Shinan Koho   1994-2005

Electronic data base consulted during the international search (name of data base and, where practicable, search terms used)
WPI

C. DOCUMENTS CONSIDERED TO BE RELEVANT

| Category* | Citation of document, with indication, where appropriate, of the relevant passages | Relevant to claim No. |
|---|---|---|
| X | JP 2004-211071 A (E.I. Du Pont De Nemours & Co.), | 1-4,7,8, 17-19 |
| Y | 29 July, 2004 (29.07.04), Claims; Par. Nos. [0001] to [0004], [0015], [0078]; examples & US 2004/0126600 A1 | 5,6,9-16 |
| Y | JP 2000-85007 A (Du Pont-Toray Co., Ltd.), 28 March, 2000 (28.03.00), Par. No. [0025] (Family: none) | 5,6 |
| Y | JP 2002-252257 A (Mitsui Mining & Smelting Co., Ltd.), 06 September, 2002 (06.09.02), Par. Nos. [0004], [0005] (Family: none) | 9-11 |

[X] Further documents are listed in the continuation of Box C.   [ ] See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 25 October, 2005 (25.10.05) | 08 November, 2005 (08.11.05) |

| Name and mailing address of the ISA/ Japanese Patent Office | Authorized officer |
|---|---|
| Facsimile No. | Telephone No. |

Form PCT/ISA/210 (second sheet) (April 2005)

**INTERNATIONAL SEARCH REPORT**

| International application No. |
|---|
| PCT/JP2005/012623 |

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2000-206326 A (Japan Aviation Electronics Industry Ltd.), 28 July, 2000 (28.07.00), Par. Nos. [0013], [0014] (Family: none) | 12,14 |
| Y | JP 2001-26085 A (Mitsubishi Chemical Corp.), 30 January, 2001 (30.01.01), Par. Nos. [0005], [0011] (Family: none) | 13,15,16 |
| A | JP 9-328544 A (E.I. Du Pont De Nemours & Co.), 22 December, 1997 (22.12.97), Full text & EP 0491307 A1 & US 5196500 A | 1-19 |
| A | JP 4-186891 A (Sumitomo Metal Industries, Ltd.), 03 July, 1992 (03.07.92), Full text (Family: none) | 1-19 |
| A | JP 2005-93771 A (Du Pont-Toray Co., Ltd.), 07 April, 2005 (07.04.05), Full text (Family: none) | 1-19 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4329690 A
- JP 9017691 A
- JP 4290742 A
- JP 62293689 A
- JP 2002252257 A
- JP 9328544 A
- JP 9188763 A
- JP 6056992 A
- JP 2000085007 A
- WO 2005119994 A
- WO 2005119995 A
- WO 2005121179 A
- WO 2005121180 A